# EUROPEAN PATENT APPLICATION

(11) **EP 4 814 936 A1**
(43) Date of publication of application: **30.09.2026**
(21) Application number: 26166731.5
(22) Date of filing: 23.03.2026
(51) Int. Cl.: G09G 3/32, G09G 3/3233, H10K 59/126, H10K 59/131

(54) **ELECTRONIC APPARATUS INCLUDING DISPLAY DEVICE**

(30) Priority: 24.03.2025 KR 20250037022
(71) Applicant: Samsung Display Co., Ltd., Yongin-si, Gyeonggi-do (KR)
(72) Inventor: Kim, Sunghwan, Yongin-si, Gyeonggi-Do (KR); Bae, Han-Sung, Yongin-si, Gyeonggi-Do (KR); Jang, Hwan-Soo, Yongin-si, Gyeonggi-Do (KR)
(74) Representative: Gulde & Partner

(57) **Abstract**

An electronic apparatus is provided. The electronic apparatus includes a base layer comprising a display area and a non-display area, a circuit layer on the base layer, and an element layer on the circuit layer, the element layer comprising a plurality of light emitting elements. The circuit layer includes a plurality of pixel driving circuits respectively connected to the plurality of light emitting elements; a plurality of data lines comprising a plurality of first data lines connected to a first group of the plurality of pixel driving circuits, and a plurality of second data lines spaced apart from the plurality of first data lines in a first direction and connected to a second group of the plurality of pixel driving circuits; and a plurality of data connection lines respectively connected to the plurality of second data lines in the display area. Each of the plurality of data connection lines includes a vertical line extending in a second direction crossing the first direction, and a horizontal line extending in the first direction and connected to the vertical line. At least two data lines of the plurality of data lines are between two adjacent vertical lines of the plurality of data connection lines.

## Description

### BACKGROUND

### 1. Field

The present disclosure herein relates to an electronic apparatus. Particularly, the present disclosure relates to an electronic apparatus including a high-resolution display panel in which a surface area of a non-display area is reduced.

### 2. Description of Related Art

Multimedia electronic apparatuses such as televisions, mobile phones, tablet computers, computers, navigation devices and game consoles, may include display panels for displaying images. A display panel may include a plurality of pixels which generates an image, and a plurality of signal lines connected to the plurality of pixels. Meanwhile, as a degree of integration of elements included in the display panel increases and the number of the signal lines increases, a surface area of an area for disposing the signal lines may increase. There may be a need to reduce the surface area of the area in which the signal lines are disposed to provide a surface area of which is large relative to a size of the electronic apparatus to a user with an electronic apparatus having a display area.

### SUMMARY

One or more embodiments comprise a display panel in which a surface area of a non-display area that is a dead space is reduced and also display quality is improved, and an electronic apparatus including the display panel.

According to an aspect of one or more embodiments, a display device may comprise a base layer comprising a display area and a non-display area; a circuit layer disposed on the base layer; and an element layer on the circuit layer, the element layer comprising a plurality of light emitting elements. The circuit layer may comprise a plurality of pixel driving circuits respectively connected to the plurality of light emitting elements; a plurality of data lines comprising a plurality of first data lines connected to a first group of the plurality of pixel driving circuits, and a plurality of second data lines spaced apart from the plurality of first data lines in a first direction and connected to a second group of the plurality of pixel driving circuits; and a plurality of data connection lines respectively connected to the plurality of second data lines in the display area. Each of the plurality of data connection lines comprises a vertical line extending in a second direction crossing the first direction, and a horizontal line extending in the first direction and connected to the vertical line. At least two data lines of the plurality of data lines are between two adjacent vertical lines of the plurality of data connection lines.

Vertical lines of the plurality of data connection lines may be at a different layer from the plurality of data lines.

Horizontal lines of the plurality of data connection lines may be at a different layer from the vertical lines. The horizontal lines may be above the plurality of data lines.

The circuit layer may further comprise a conductive pattern between the plurality of data lines and the plurality of light emitting elements. The conductive pattern may be configured to receive a constant voltage.

The conductive pattern may overlap one of the plurality of light emitting elements in a third direction crossing the first direction and the second direction. The conductive pattern may overlap, in the third direction, one or more of the plurality of data lines that overlap the one of the plurality of light emitting elements.

The second group of the plurality of pixel driving circuits may be closer to the non-display area in the first direction than the first group of the plurality of pixel driving circuits.

Each of a plurality of pixel units may comprise at least two of the plurality of light emitting elements, and is connected to at least one of the plurality of first data lines.

Each of the plurality of pixel units may further comprise a first light emitting element configured to emit light of a first color; a second light emitting element configured to emit light of a second color different from the first color, and spaced from the first light emitting element in the first direction; and a third light emitting element configured to emit light of a third color different from the first color and the second color, and spaced from the first light emitting element in the first direction and from the second light emitting element in the second direction. One of the first light emitting element, the second light emitting element, and the third light emitting element may be connected to one of vertical lines of the plurality of data connection lines. Others of the first light emitting element, the second light emitting element, and the third light emitting element may be respectively connected to corresponding first data lines of the plurality of first data lines.

One light emitting element of the first light emitting element, the second light emitting element, and third light emitting element may overlap at least one of the plurality of first data lines in the third direction. A conductive pattern may be between the one light emitting element and the at least one of the plurality of first data lines. The conductive pattern may overlap the one light emitting element and the at least one of the plurality of first data lines in the third direction.

According to an aspect of one or more embodiments, an electronic apparatus may comprise a display panel; a processor connected to the display panel; and a power supply configured to supply power to the processor. The display panel may comprise a base layer comprising a display area and a non-display; a circuit layer on the base layer; and an element layer on the circuit layer, the element layer comprising a plurality of light emitting elements each comprising a first electrode. The circuit layer may comprise a plurality of pixel driving circuits respectively connected to the plurality of light emitting elements; a plurality of data lines comprising a plurality of first data lines connected to a first group of the plurality of pixel driving circuits, and a plurality of second data lines spaced from the plurality of first data lines in a first direction and connected to a second group of the plurality of pixel driving circuits; a plurality of data connection lines respectively connected to the plurality of second data lines in the display area; and a shield pattern which is at the same layer as the plurality of data connection lines, and is configured to receive a constant voltage. Each of the plurality of data connection lines may comprise a vertical line extending in a second direction crossing the first direction, and a horizontal line extending in the first direction and connected to the vertical line. Vertical lines of the plurality of data connection lines may be at a different layer from the plurality of data lines. The vertical lines may be respectively between first electrodes of the plurality of light emitting elements spaced from each other in the first direction. The shield pattern may overlap at least a portion of the plurality of data lines in a third direction crossing the first direction and the second direction.

At least a portion of the plurality of data lines may overlap the first electrodes on a plane, and the shield pattern may overlap the first electrodes in the third direction.

The plurality of pixel driving circuits may be configured to receive a first driving voltage and a second driving voltage which are different from each other. A second electrode opposing the first electrodes of the plurality of light emitting elements may be configured to receive the second driving voltage. The shield pattern may be configured to receive the first driving voltage.

At least two data lines of the plurality of data lines may overlap one of the first electrodes in the third direction. The shield pattern may overlap the at least two data lines in the third direction.

The plurality of data lines may comprise six data lines arranged in the first direction in a certain area, and the vertical lines comprise two vertical lines arranged in the first direction in the certain area.

The horizontal line may be at a different layer from the vertical line and the plurality of data lines.

The plurality of pixel driving circuits may comprise a first semiconductor pattern comprising a silicon semiconductor, and a second semiconductor pattern comprising an oxide semiconductor.

The plurality of pixel driving circuits may comprise a first gate electrode pattern overlapping the first semiconductor pattern in the third direction, and a second gate electrode pattern overlapping the second semiconductor pattern in the third direction. The horizontal line may be disposed on the first gate electrode pattern and the second gate electrode pattern.

According to an aspect of one or more embodiments, a method of manufacturing a display device may comprise providing a base layer including a display area and a non-display area; disposing a circuit layer on the base layer, the circuit layer including a plurality of pixel driving circuits, a plurality of data lines, and a plurality of data connection lines, the plurality of data lines including a plurality of first data lines and a plurality of second data lines, each of the plurality of data connection lines including a vertical line extending in a second direction crossing a first direction, and a horizontal line extending in the first direction and connected to the vertical line; disposing an element layer to be on the circuit layer, the element layer including a plurality of light emitting elements; respectively connecting the plurality of pixel driving circuits to the plurality of light emitting elements; connecting the plurality of first data lines to a first group of the plurality of pixel driving circuits and the plurality of second data lines to a second group of the plurality of pixel driving circuits, the plurality of second data lines being spaced apart from the plurality of first data lines in the first direction; respectively connecting the plurality of data connection lines to the plurality of second data lines in the display area; and disposing at least two data lines of the plurality of data lines between two adjacent vertical lines of the plurality of data connection lines.

The method may further comprise disposing a conductive pattern between the plurality of data lines and the plurality of light emitting elements at the same layer as vertical lines of the plurality of data connection lines.

### BRIEF DESCRIPTION OF DRAWINGS

Various embodiments in accordance with the present disclosure will be described with reference to the drawings, in which:
FIG. 1 illustrates an example display device in a perspective view, according to one or more embodiments;
FIG. 2A illustrates an example display device in an exploded perspective view, according to one or more embodiments;
FIG. 2B illustrates an example display device in a cross-sectional view, according to one or more embodiments ;
FIG. 3 illustrates an example block diagram of a display device, according to one or more embodiments;
FIG. 4A illustrates an example circuit diagram of a pixel, according to one or more embodiments;
FIG. 4B illustrates an example waveform diagram of an operation of the pixel illustrated in FIG. 4A;
FIG. 5A illustrates a display panel in plan view, according to one or more embodiments;
FIG. 5B illustrates a portion of an example display panel in a cross-sectional view, according to one or more embodiments;
FIGS. 6A and 6B each illustrates one or more portions of an example display panel in a magnified plan view, according to one or more embodiments;
FIGS. 7A, 7B, 7C, 7D, 7E, 7F, 7G, 7H, 7I, and 7J each illustrates an example display panel, in various plan views, according to one or more embodiments;
FIGS. 8A, 8B, and 8C each illustrates an example display panel are plan views of a display panel, according to one or more embodiments;
FIG. 9A illustrates a portion of an example display panel in a schematic plain view, according to one or more embodiments;
FIG. 9B illustrates a portion of the example display panel illustrated in FIG. 9A in a cross-sectional view;
FIG. 10 illustrates an example block diagram of an electronic apparatus, according to one or more embodiments; and
FIG. 11 illustrates an example schematic diagram of one or more electronic apparatuses, according to one or more embodiments.

### DETAILED DESCRIPTION

One or more embodiments according to the present disclosure will be described in detail with reference to the accompanying drawings. For purposes of explanation, specific configurations and details are set forth in order to provide a thorough understanding of possible ways of implementing the techniques. However, it will also be apparent that the techniques described below may be practiced in different configurations without the specific details. Furthermore, well-known features may be omitted or simplified to avoid obscuring the techniques being described.

Other variations are within spirit of present disclosure. Thus, while disclosed techniques are susceptible to various modifications and alternative constructions, certain illustrated embodiments thereof are shown in drawings and have been described above in detail. It should be understood, however, that there is no intention to limit disclosure to specific form or forms disclosed, but on the contrary, intention is to cover all modifications, alternative constructions, and equivalents falling within spirit and scope of disclosure, as defined in appended claims.

It will be understood that when an element or layer is referred to as being "on," "connected to" or "coupled to" another element or layer, it can be directly on, connected or coupled to the other element or layer, or intervening elements or layers may be present. By contrast, when an element is referred to as being "directly on," "directly connected to," or "directly coupled to" another element or layer, there are no intervening elements or layers present.

Use of terms such as "a" and "an" and "the" and similar referents in context of describing disclosed embodiments (especially in context of following claims) are to be construed to cover both singular and plural, unless otherwise indicated herein or clearly contradicted by context, and not as a definition of a term. Number of items in a plurality is at least two, but can be more when so indicated either explicitly or by context.

Terms such as "comprising," "having," "including," and "containing" are to be construed as open-ended terms (meaning "including, but not limited to,") unless otherwise noted. Recitation of ranges of values herein are merely intended to serve as a shorthand method of referring individually to each separate value falling within range, unless otherwise indicated herein and each separate value is incorporated into specification as if it were individually recited herein.

Terms such as "set" (e.g., "a set of items") or "subset" unless otherwise noted or contradicted by context, is to be construed as a nonempty collection comprising one or more members. Further, unless otherwise noted or contradicted by context, term "subset" of a corresponding set does not necessarily denote a proper subset of corresponding set, but subset and corresponding set may be equal.

Conjunctive language, such as phrases of form "at least one of A, B, and C," or "at least one of A, B and C," unless specifically stated otherwise or otherwise clearly contradicted by context, is otherwise understood with context as used in general to present that an item, term, etc., may be either A or B or C, or any nonempty subset of set of A and B and C. For instance, in illustrative example of a set having three members, conjunctive phrases "at least one of A, B, and C" and "at least one of A, B and C" refer to any of the following sets: {A}, {B}, {C}, {A, B}, {A, C}, {B, C}, {A, B, C}. Thus, such conjunctive language is not generally intended to imply that certain embodiments require at least one of A, at least one of B and at least one of C each to be present. In addition, unless otherwise noted or contradicted by context, term "plurality" indicates a state of being plural (e.g., "a plurality of items" indicates multiple items).

Further, unless stated otherwise or otherwise clear from context, phrase "based on" means "based at least in part on" and not "based solely on."

As used herein, terms "first," "second," "third," "fourth," etc. are used merely to distinguish elements from one another and thus do not denote any particular order unless an order is specifically described. For example, the term "second" may be used without using the term "first". Also, although the terms "first," "second," "third," and so on may be used herein to describe various elements, components, regions, layers and/or sections, these elements, components, regions, layers and/or sections should not be limited by these terms.

Same reference numerals or symbols may refer to the same elements or components. In the drawings, the thickness, ratio, and size of the elements or components may be exaggerated to effectively describe one or more embodiments.

As used herein, the term "and/or" includes any and all combinations of one or more of the associated listed elements.

In addition, terms such as "below," "under," "on the lower side," "above," "over," "on the upper side," or the like may be used to describe the relationships between the elements illustrated in the drawings. These terms may be used to describe relationships between the elements and are described based on the directions indicated in the drawings.

Unless otherwise defined, all terms (including technical and scientific terms) used herein may include one or more meanings commonly understood by one of ordinary skill in the art with respect to the present disclosure. It will be further understood that terms, such as those defined in commonly used dictionaries, may be interpreted as having a meaning that is consistent with their meaning in the context of the relevant art and will not be interpreted in an idealized or overly formal sense unless expressly so defined herein.

It will be further understood that the terms "comprises, includes, has" and/or "comprising, including, having," when used in this specification, specify the presence of stated features, numbers, steps, operations, elements, components or combinations thereof, but do not preclude the possibility of the presence or addition of one or more other features, numbers, steps, operations, elements, components, and/or combinations thereof.

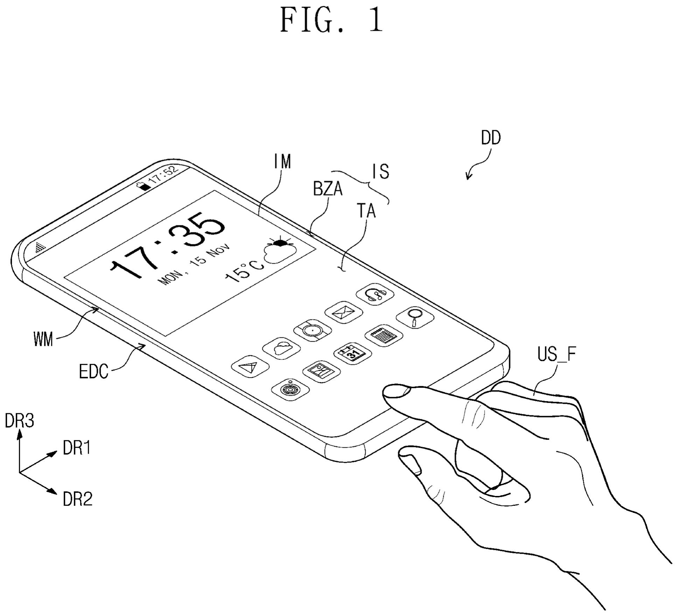

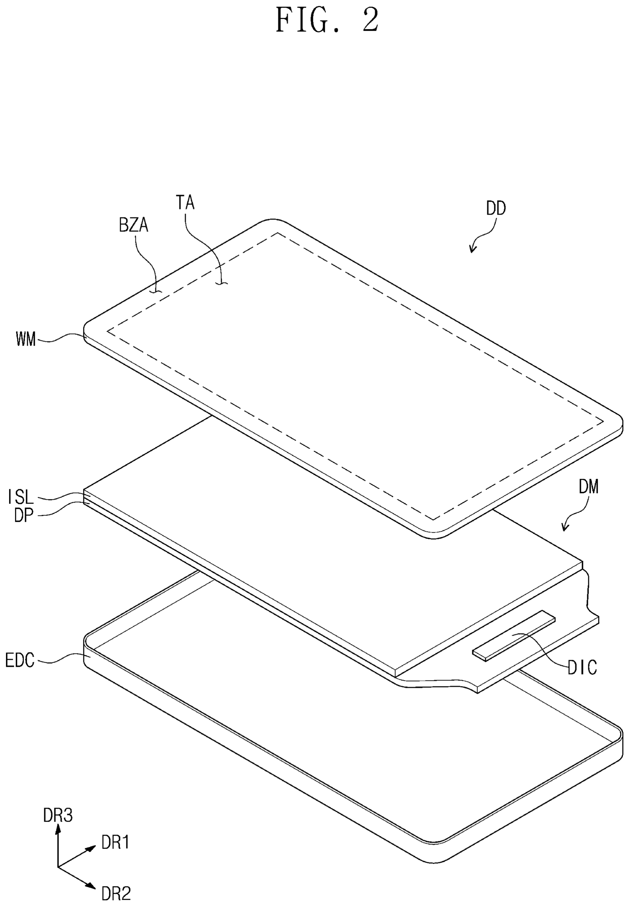

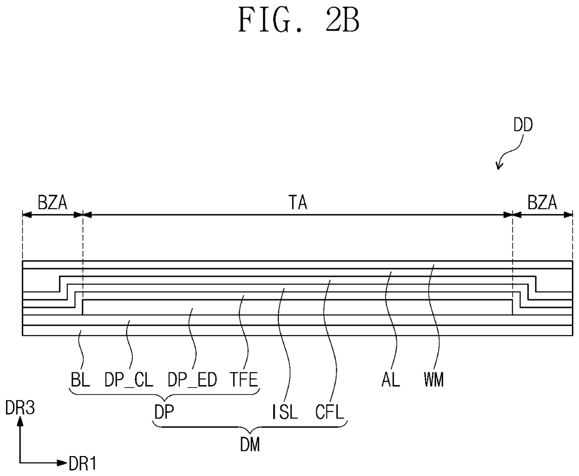

FIG. 1 illustrates an example display device in a perspective view, according to one or more embodiments. FIG. 2A illustrates an example display device in an exploded perspective view, according to one or more embodiments. FIG. 2B illustrates an example display device in a cross-sectional view, according to one or more embodiments.

Referring to FIGS. 1, 2A and 2B, a display device DD according to one or more embodiments of the present disclosure may have a rectangular shape having short sides parallel to a first direction DR1 and long sides parallel to a second direction DR2 crossing the first direction DR1. However, according to one or more embodiments of the present disclosure are not limited thereto, and the display device DD may have various shapes such as a circular shape and a polygon shape.

The display device DD may be a device which is activated in response to an electrical signal. The display device DD may include various embodiments. For example, the display device DD may be applied to an electronic apparatus such as a smartwatch, a tablet computer, a notebook computer, a computer, or a smart television.

Hereinafter, a normal direction substantially perpendicular to a plane defined by the first direction DR1 and the second direction DR2 is defined as a third direction DR3. The phrase "in plan view" used herein may indicate a state when viewed in the third direction DR3.

A top surface of the display device DD may be defined as a display surface IS and may be parallel to a plane defined by the first direction DR1 and the second direction DR2. Images IM generated by the display device DD may be provided for a user through the display surface IS.

The display surface IS may be divided into a transmission area TA and a bezel area BZA. The transmission area TA may be an area on which the images IM are displayed. The images IM are visible to the user through the transmission area TA. In one or more embodiments, the transmission area TA is illustrated as having a rectangular shape with rounded vertices. However, this is illustrated as an example, and the transmission area TA may have various shapes.

The bezel area BZA is adjacent to the transmission area TA. The bezel area BZA may have a certain color. The bezel area BZA may surround the transmission area TA. Accordingly, the shape of the transmission area TA may be substantially defined by the bezel area BZA. However, this is illustrated as an example, and the bezel area BZA may be arranged adjacent to only one side of the transmission area TA or may be omitted.

The display device DD may sense an external input applied from the outside. The external input may include various types of inputs provided from the outside of the display device DD. For example, the external input may include not only a touch by part of the body such as a user's hand US_F, or a touch by a separate device (e.g., an active pen or a digitizer), but also an external input (e.g., hovering) applied by approaching the display device DD or being adjacent thereto by a certain distance. In addition, the external input may include various types such as force, pressure, temperature, and light.

The display device DD may sense a user's biometric information applied from the outside. A biometric information sensing area capable of sensing the user's biometric information may be provided to the display surface IS of the display device DD. The biometric information sensing area may be provided to an entire area of the transmission area TA or may be provided to a partial area of the transmission area TA. For example, FIG. 1 illustrates one or more embodiments in which the entirety of the transmission area TA is utilized as the biometric information sensing area.

The display device DD may include a window WM, a display module DM, and a housing EDC. In one or more embodiments, the window WM and the housing EDC may be coupled to each other to constitute an outer appearance of the display device DD.

A front surface of the window WM may define the display surface IS of the display device DD. The window WM may include an optically transparent insulating material. For example, the window WM may include glass or plastic. The window WM may have a multilayer structure or a single-layer structure. For example, the window WM may include a plurality of plastic films coupled to each other through an adhesive, or include a glass substrate and a plastic film coupled to each other through an adhesive.

The display module DM may include a display panel DP and an input sensing layer ISL. The display panel DP may display an image in response to an electrical signal, and the input sensing layer ISL may sense an external input applied from the outside. The external input may be provided in various types.

The display panel DP according to one or more embodiments of the present disclosure may be an emissive display panel and is not particularly limited. For example, the display panel DP may be an organic light emitting display panel, an inorganic light emitting display panel, or a quantum dot light emitting display panel. An emission layer of the organic light emitting display panel may include an organic light emitting material, and an emission layer of the inorganic light emitting display panel may include an inorganic light emitting material. An emission layer of the quantum dot light emitting display panel may include a quantum dot, a quantum rod, and the like. Hereinafter, the display device DD is described as the organic light emitting display panel.

Referring to FIG. 2B, the display panel DP may include a base layer BL, a circuit layer DP-CL, an element layer DP_ED, and an encapsulation layer TFE. The display panel DP according to one or more embodiments of the present disclosure may be a flexible display panel. However, according to one or more embodiments of the present disclosure may not be limited thereto. For example, the display panel DP may be a foldable display panel folded around a folding axis, or a rigid display panel.

The base layer BL may include a synthetic resin layer. The synthetic resin layer may be a polyimide-based resin layer, and a material thereof is not particularly limited. In addition, the base layer BL may include a glass substrate, a metal substrate, an organic/inorganic composite material substrate, or the like.

The circuit layer DP_CL may be disposed on the base layer BL. The circuit layer DP_CL may be disposed between the base layer BL and the element layer DP_ED. The circuit layer DP_CL may include at least one insulating layer and a circuit element. Hereinafter, the insulating layer included in the circuit layer DP_CL may be referred to as an intermediate insulating layer. The intermediate insulating layer may include at least one intermediate inorganic film and at least one intermediate organic film. The circuit element may include a pixel driving circuit or the like included in each of a plurality of pixels for displaying an image. The circuit layer DP_CL may further include a pixel driving circuit and/or signal lines connected thereto.

As described further herein, the element layer DP_ED may include a light emitting element included in each of the pixels.

The encapsulation layer TFE seals the element layer DP_ED. The encapsulating layer TFE may include at least one organic layer and at least one inorganic layer. The inorganic layer may include an inorganic material and protect the element layer DP_ED from moisture/oxygen. The inorganic layer may include a silicon nitride layer, a silicon oxynitride layer, a silicon oxide layer, a titanium oxide layer, or an aluminum oxide layer, but is not particularly limited thereto. The organic layer may include an organic material and protect the element layer DP_ED from foreign matter such as dust particles.

The input sensing layer ISL may be provided on the display panel DP. The input sensing layer ISL may be directly disposed on the encapsulation layer TFE. According to one or more embodiments of the present disclosure, the input sensing layer ISL may be formed on the display panel DP through a continuous process. That is, when the input sensing layer ISL is directly disposed on the display panel DP, an adhesive film is not disposed between the input sensing layer ISL and the encapsulation layer TFE. Alternatively, an adhesive film may be disposed between the input sensing layer ISL and the display panel DP. In this case, the input sensing layer ISL may not be manufactured together with the display panel DP through a continuous process, and the input sensing layer ISL may be manufactured through a separate process from the display panel DP and then fixed to a top surface of the display panel DP through an adhesive film.

The input sensing layer ISL may sense an external input (e.g., user's touch) to covert the external input into a certain input signal, and provide the input signal to the display panel DP. The input sensing layer ISL may include a plurality of sensing electrodes for sensing the external input. The sensing electrodes may sense the external input by using a capacitance method. The display panel DP may receive an input signal from the input sensing layer ISL, and generate an image corresponding to the input signal.

The display module DM may further include a color filter layer CFL. For example, the color filter layer CFL may be disposed on the input sensing layer ISL. However, according to one or more embodiments of the present disclosure may not be limited thereto. The color filter layer CFL may be disposed between the display panel DP and the input sensing layer ISL. The color filter layer CFL may include a plurality of color filters and a black matrix.

Structures of the input sensing layer ISL and the color filter layer CFL will be described later in detail.

The display device DD according to one or more embodiments of the present disclosure may further include an adhesive layer AL. The window WM may be attached to the input sensing layer ISL through the adhesive layer AL. The adhesive layer AL may include an optical clear adhesive, an optically clear adhesive resin, or a pressure sensitive adhesive (PSA).

The housing EDC may be coupled to the window WM. The housing EDC may be coupled to the window WM and provides a certain inner space. The display module DM may be accommodated in the inner space. The housing EDC may include a material having relatively high rigidity. For example, the housing EDC may include a plurality of frames and/or plates, each of which includes glass, plastic or metal or includes a combination thereof. The housing EDC may stably protect components of the display device DD, accommodated in the inner space, from external impact. Although not illustrated, a battery module or the like which supplies power necessary for an overall operation of the display device DD may be disposed between the display module DM and the housing EDC.

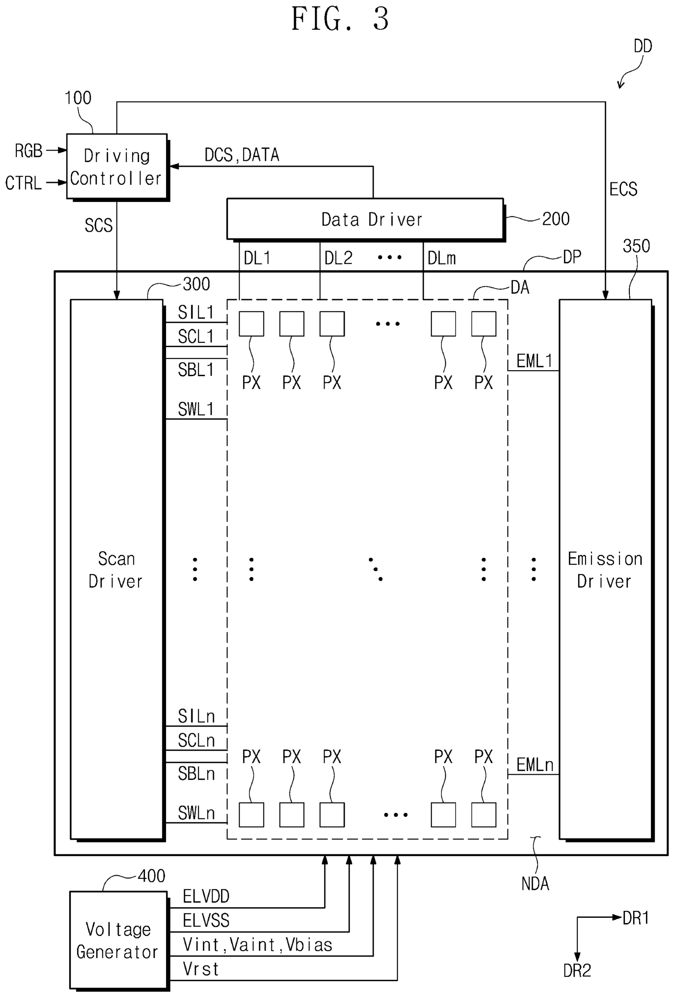

FIG. 3 illustrates an example block diagram of a display device, according to one or more embodiments. Referring to FIG. 3, a display device DD may include a display panel DP, a panel driver, and a driving controller 100. For example, the panel driver includes a data driver 200, a scan driver 300, an emission driver 350, and a voltage generator 400.

The driving controller 100 may receive an image signal RGB and a control signal CTRL. The driving controller 100 generates image data DATA by converting a data format of the image signal RGB to match an interface specification of the data driver 200. The driving controller 100 may output a first control signal SCS, a second control signal ECS, a third control signal DCS, and a fourth control signal RCS.

The data driver 200 may receive the third control signal DCS and the image data DATA from the driving controller 100. The data driver 200 may convert the image data DATA to data signals, and output the data signals to a plurality of data lines DL1 to DLm to be described later. The data signals may be analog voltages corresponding to a grayscale value of the image data DATA. For example, the data driver 200 may be built in a driving chip DIC illustrated in FIG. 2A.

The scan driver 300 may receive the first control signal SCS from the driving controller 100. The scan driver 300 may output scan signals to scan lines in response to the first control signal SCS.

The voltage generator 400 may generate voltages necessary for an operation of the display panel DP. In one or more embodiments, the voltage generator 400 generates a first driving voltage ELVDD, a second driving voltage ELVSS, a first initialization voltage Vint, a second initialization voltage Vaint, a bias voltage Vbias, and a reset voltage Vrst.

In the display panel DP, the display area DA and the non-display area NDA may be defined. For example, the display panel DP may include a display area DA corresponding to the transmission area TA (see FIG. 1) and a non-display area NDA corresponding to the bezel area BZA (see FIG. 1).

The display panel DP may include a plurality of pixels PX disposed in the display area DA. The pixels PX may be arranged in the form of a matrix in the first and second directions DR1 and DR2. However, according to one or more embodiments of the present disclosure are not limited thereto, and an arrangement shape of the pixels PX may be variously changed.

The display panel DP may include initialization scan lines SIL1 to SILn, compensation scan lines SCL1 to SCLn, write scan lines SWL1 to SWLn, black scan lines SBL1 to SBLn, emission control lines EML1 to EMLn, and data lines DL1 to DLm. The initialization scan lines SIL1 to SILn, the compensation scan lines SCL1 to SCLn, the write scan lines SWL1 to SWLn, the black scan lines SBL1 to SBLn, and the emission control lines EML1 to EMLn may extend in the first direction DR1. The initialization scan lines SIL1 to SILn, the compensation scan lines SCL1 to SCLn, the write scan lines SWL1 to SWLn, the black scan lines SBL1 to SBLn, and the emission control lines EML1 to EMLn may be arranged to be spaced apart from each other in the second direction DR2. The data lines DL1 to DLm may extend in the second direction DR2 and may be arranged to be spaced apart from each other in the first direction DR1. Here, n, m, and h may be each a natural number of 1 or more.

The pixels PX may be respectively electrically connected to the initialization scan lines SIL1 to SILn, the compensation scan lines SCL1 to SCLn, the write scan lines SWL1 to SWLn, the black scan lines SBL1 to SBLn, the emission control lines EML1 to EMLn, and the data lines DL1 to DLm. For example, each of the pixels PX may be electrically connected to four scan lines. However, the number of the scan lines connected to each of the pixels PX may not be limited thereto and may be changed.

The scan driver 300 may be disposed in the non-display area NDA of the display panel DP. The scan driver 300 may receive the first control signal SCS from the driving controller 100. In response to the first control signal SCS, the scan driver 300 may output initialization scan signals to the initialization scan lines SIL1 to SILn, and output compensation scan signals to the compensation scan lines SCL1 to SCLn. In addition, in response to the first control signal SCS, the scan driver 300 may output write scan signals to the write scan lines SWL1 to SWLn, and output black scan signals to the black scan lines SBL1 to SBLn. Alternatively, the scan driver 300 may include first and second scan drivers. The first scan driver may output the initialization scan signals and the compensation scan signals, and the second scan driver may output the write scan signals and the black scan signals.

The emission driver 350 may be disposed in the non-display area NDA of the display panel DP. The emission driver 350 receives the second control signal ECS from the driving controller 100. In response to the second control signal ECS, the emission driver 350 may output emission control signals to the emission control lines EML1 to EMLn. Alternatively, the scan driver 300 may be connected to the emission control lines EML1 to EMLn. In this case, the emission driver 350 may be omitted, and the scan driver 300 may output the emission control signals to the emission control lines EML1 to EMLn.

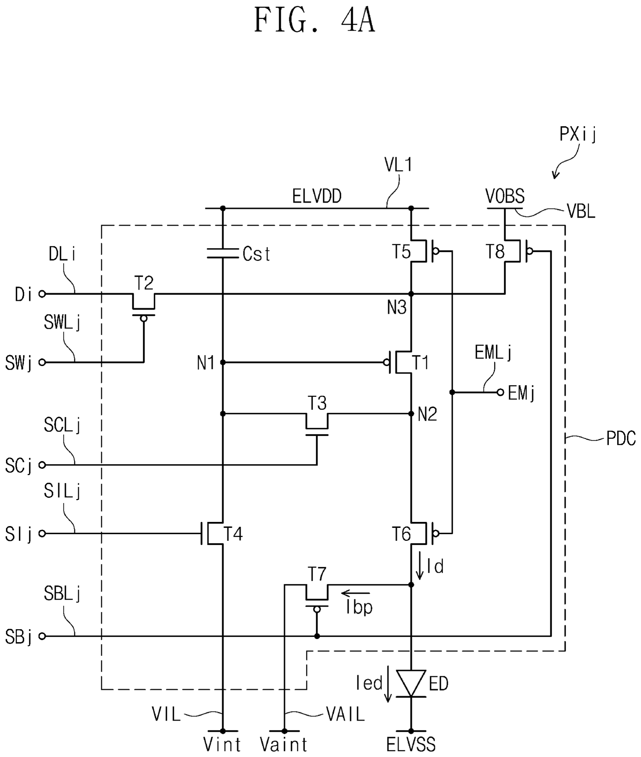

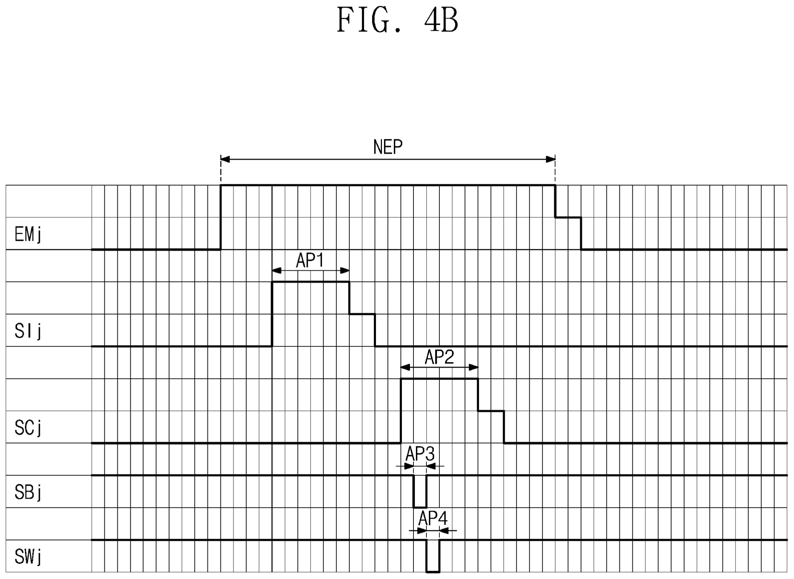

FIG. 4A illustrates an example circuit diagram of a pixel, according to one or more embodiments. FIG. 4B illustrates an example waveform diagram of an operation of the pixel illustrated in FIG. 4A.

As an example, FIG. 4A illustrates an equivalent circuit diagram of one pixel PXij among the pixels PX illustrated in FIG. 3. The circuit structure of the pixel PXij may be further described herein.

Referring to FIG. 4A, the pixel PXij may be connected to an i-th data line DLi of data lines DL1 to DLm, a j-th initialization scan line SILj of initialization scan lines SIL1 to SILn, a j-th compensation scan line SCLj of compensation scan lines SCL1 to SCLn, a j-th write scan line SWLj of write scan lines SWL1 to SWLn, a j-th black scan line SBLj of black scan lines SBL1 to SBLn, and a j-th emission control line EMLj of emission control lines EML1 to EMLn.

The pixel PXij may include a light emitting element ED and a pixel driving circuit PDC. The light emitting element ED may be a light emitting diode. For example, the light emitting element ED may be an organic light emitting diode including an organic emission layer.

The pixel driving circuit PDC may include first to eighth transistors T1, T2, T3, T4, T5, T6, T7 and T8, and one capacitor Cst. At least one of the first to eighth transistors T1 to T8 may be a transistor having a low-temperature polycrystalline silicon (LTPS) semiconductor layer. Some of the first to eighth transistors T1 to T8 may be p-type transistors, and the others may be n-type transistors. At least one of the first to eighth transistors T1 to T8 may be a transistor having an oxide semiconductor layer. For example, the third and fourth transistors T3 and T4 may be oxide semiconductor transistors, and the first, second, and fifth to eighth transistors T1, T2 and T5 to T8 may be LTPS transistors. The third and fourth transistors T3 and T4 may be NMOS transistors.

The configuration of the pixel driving circuit PDC according to one or more embodiments of the present disclosure may not be limited to one or more embodiments illustrated in FIG. 4A. The pixel driving circuit PDC illustrated in FIG. 4A is just one example, and the configuration of the pixel driving circuit PDC may be modified. For example, all the first, second, and fifth to eighth transistors T1, T2 and T5 to T8 may be p-type transistors or n-type transistors.

The j-th initialization scan line SILj, the j-th compensation scan line SCLj, the j-th write scan line SWLj, the j-th black scan line SBLj, and the j-th emission control line EMLj may transmit, to the pixel PXij, a j-th initialization scan signal SIj, a j-th compensation scan signal SCj, a j-th write scan signal SWj, a jth black scan signal SBj, and a j-th emission control signal EMj, respectively. The i-th data line DLi transmits an i-th data signal Di to the pixel PXij. The i-th data signal Di may have a voltage level corresponding to the image signal RGB (see FIG. 3) input to the display device DD (see FIG. 3).

For example, the pixel PXij may be connected to first and second driving voltage lines VL1 and VL2, first and second initialization voltage lines VIL and VAIL, and a bias voltage line VBL. The first driving voltage line VL1 may transmit a first driving voltage ELVDD to the pixel PXij, and the second driving voltage line VL2 may transmit a second driving voltage ELVSS to the pixel PXij. In addition, the first initialization voltage line VIL may transmit a first initialization voltage Vint to the pixel PXij, and the second initialization voltage line VAIL may transmit a second initialization voltage Vaint to the pixel PXij. The bias voltage line VBL may transmit a bias voltage Vbias to the pixel PXij.

The first transistor T1 may be connected between the light emitting element ED and the first driving voltage line VL1 which receive the first driving voltage ELVDD. The first transistor T1 includes a first electrode connected to the first driving voltage line VL1 via the fifth transistor T5, a second electrode connected to an anode electrode of the light emitting element ED via the sixth transistor T6, and a third electrode (e.g., a gate electrode) connected to one end (e.g., a first node N1) of the capacitor Cst. The first transistor T1 may receive the i-th data signal Di transmitted from the i-th data line DLi according to a switching operation of the second transistor T2, and then supply a driving current Id to the light emitting element ED.

The second transistor T2 may be connected between the i-th data line DLi and the first electrode of the first transistor T1. The second transistor T2 may include a first electrode connected to the i-th data line DLi, a second electrode connected to the first electrode of the first transistor T1, and a third electrode (e.g., a gate electrode) connected to the j-th write scan line SWLj. The second transistor T2 may be turned on in response to the j-th write scan signal SWj received through the j-th write scan line SWLj, and then transmit the i-th data signal Di received from the i-th data line DLi to the first electrode of the first transistor T1.

The third transistor T3 may be connected between the second electrode of the first transistor T1 and the first node N1. The third transistor T3 may include a first electrode connected to the third electrode of the first transistor T1, a second electrode connected to the second electrode of the first transistor T1, and a third electrode (e.g., a gate electrode) connected to the j-th compensation scan line SCLj. The third transistor T3 may be turned on in response to the j-th compensation scan signal SCj received through the j-th compensation scan line SCLj, and then connect the third electrode and the second electrode of the first transistor T1 to each other so that the first transistor T1 is diode-connected.

The fourth transistor T4 is connected between the first node N1 and the first initialization voltage line VIL to which the first initialization voltage Vint is applied. The fourth transistor T4 may include a first electrode connected to the first initialization voltage line VIL to which the first initialization voltage Vint is transmitted, a second electrode connected to the first node N1, and a third electrode (e.g., a gate electrode) connected to the j-th initialization scan line SILj. The fourth transistor T4 may be turned on in response to the j-th initialization scan signal SIj received through the j-th initialization scan line SILj. The turned-on fourth transistor T4 may transmit the first initialization voltage Vint to the first node N1 and initializes an electric potential of the third electrode (i.e., an electric potential of the first node N1) of the first transistor T1.

The fifth transistor T5 may include a first electrode connected to the first driving voltage line VL1, a second electrode connected to the first electrode of the first transistor T1, and a third electrode (e.g., a gate electrode) connected to the j-th emission control line EMLj.

The sixth transistor T6 may include a first electrode connected to the second electrode of the first transistor T1, a second electrode connected to the anode electrode of the light emitting element ED, and a third electrode (e.g., a gate electrode) connected to the j-th emission control line EMLj.

The fifth and sixth transistors T5 and T6 may be turned on at the same time in response to the j-th emission control signal EMj received through the j-th emission control line EMLj. The first driving voltage ELVDD applied through the turned-on fifth transistor T5 may be compensated through the diode-connected first transistor T1, and then transmitted to the light emitting element ED.

The seventh transistor T7 may include a first electrode connected to the second initialization voltage line VAIL to which the second initialization voltage Vaint is transmitted, a second electrode connected to the second electrode of the sixth transistor T6, and a third electrode (e.g., a gate electrode) connected to the j-th black scan line SBLj. The second initialization voltage Vaint may have a voltage level lower than or equal to that of the first initialization voltage Vint.

The eighth transistor T8 may include a first electrode connected to the bias voltage line VBL to which the bias voltage Vbias is transmitted, a second electrode connected to the first electrode of the first transistor T1, and a third electrode (e.g., a gate electrode) connected to the j-th black scan line SBLj.

The seventh and eighth transistors T7 and T8 may be turned on at the same time in response to the j-th black scan signal SBj received through the j-th black scan line SBLj. The second initialization voltage Vaint applied through the turned-on seventh transistor T7 may be transmitted to the anode electrode of the light emitting element ED. Thus, the anode electrode of the light emitting element ED may be initialized with the second initialization voltage Vaint. The bias voltage Vbias applied through the turned-on eighth transistor T8 may be transmitted to the first electrode of the first transistor T1. Thus, the bias voltage Vbias may be periodically applied to the first electrode of the first transistor T1, thereby preventing a display quality deterioration occurring when a difference in electric potential between the first and second electrodes of the first transistor T1 is increased to a certain level or higher by hysteresis.

As described above, one end of the capacitor Cst is connected to the third electrode of the first transistor T1, and the other end thereof is connected to the first driving voltage line VL1. A cathode electrode of the light emitting element ED may be connected to the second driving voltage line VL2 which transmits the second driving voltage ELVSS. The second driving voltage ELVSS may have a lower voltage level than the first driving voltage ELVDD. For example, the second driving voltage ELVSS may have a lower voltage level than each of the first and second initialization voltages Vint and Vaint.

Referring to FIGS. 4A and 4B, the j-th emission control signal EMj may have a high level during a non-emission period NEP. The j-th initialization scan signal SIj may be activated within the non-emission period NEP. When the j-th initialization scan signal SIj having a high level may be provided through the j-th initialization scan line SILj during an activation period AP1 (hereinafter referred to as a first activation period) of the j-th initialization scan signal SIj, the fourth transistor T4 may be turned on in response to the j-th initialization scan signal SIj having a high level. The first initialization voltage Vint may be transmitted to the third electrode of the first transistor T1 through the turned-on fourth transistor T4, and the first node N1 may be initialized with the first initialization voltage Vint. Thus, the first activation period AP1 may be defined as an initialization period of the pixel PXij.

Then, when the j-th compensation scan signal SCj is activated and the j-th compensation scan signal SCj having a high level is supplied through the j-th compensation scan line SCLj during an activation period AP2 (hereinafter referred to as a second activation period) of the j-th compensation scan signal SCj, the third transistor T3 may be turned on. The first transistor T1 may be diode-connected by the turned-on third transistor T3 and is biased in a forward direction. The first activation period AP1 may not overlap the second activation period AP2.

The j-th write scan signal SWj may be activated within the second activation period AP2. The j-th write scan signal SWj may have a low level during an activation period AP4 (hereinafter referred to as a fourth activation period). During the fourth activation period AP4, the second transistor T2 may be turned on by the j-th write scan signal SWj having a low level. Then, a compensation voltage ("Di-Vth"), which is reduced from the i-th data signal Di supplied from the i-th data line DLi by a threshold voltage Vth of the first transistor T1, may be applied to the third electrode of the first transistor T1. That is, an electric potential of the third electrode of the first transistor T1 may become the compensation voltage ("Di-Vth"). The fourth activation period AP4 may overlap the second activation period AP2. A duration time of the second activation period AP2 may be longer than a duration time of the fourth activation period AP4.

The first driving voltage ELVDD and the compensation voltage ("Di-Vth") may be applied to both ends of the capacitor Cst, and a charge corresponding to a difference in voltage between both the ends may be stored in the capacitor Cst. Here, a section of the high level of the j-th compensation scan signal SCj may be referred to as a compensation section of the pixel PXij.

Meanwhile, the j-th black scan signal SBj may be activated within the second activation period AP2 of the j-th compensation scan signal SCj. The j-th black scan signal SBj has a low level during an activation period AP3 (hereinafter referred to as a third activation period). During the third activation period AP3, the seventh transistor T7 may be turned by receiving the j-th black scan signal SBj having a low level through the j-th black scan line SBLj. The seventh transistor T7 may allow a portion of the driving current Id to pass as a bypass current Ibp through the seventh transistor T7. The third activation period AP3 may overlap the second activation period AP2. A duration time of the second activation period AP2 may be longer than a duration time of the third activation period AP3. The third activation period AP3 may precede the fourth activation period AP4 and not overlap the fourth activation period AP4.

In a case in which the pixel PXij displays a black image, even though the minimum driving current of the first transistor T1 flows as the driving current Id, the pixel PXij may not normally display the black image when the light emitting element ED emits light. Thus, the seventh transistor T7 in the pixel PXij according to one or more embodiments of the present disclosure may distribute, as the bypass current Ibp, a portion of the minimum driving current of the first transistor T1 to a current passage other than a current passage to the light emitting element ED. Here, the minimum driving current of the first transistor T1 may refer to a current which flows to the first transistor T1 under the condition that a gate-source voltage Vgs of the first transistor T1 is lower than the threshold voltage Vth and thus the first transistor T1 is off. The minimum driving current (e.g., a current of about 10 pA or lower) flowing to the first transistor T1 under this condition for allowing the first transistor T1 to be off may be transmitted to the light emitting element ED so that an image having a black grayscale is displayed. It can be said that the bypass current Ibp may have a relatively great influence on the minimum driving current when the pixel PXij displays a black image, but the bypass current Ibp may hardly have an influence on the driving current Id when the pixel PXij displays an image such as a general image or a white image. Thus, when a black image is displayed, a current (i.e., an emission current Ied) reduced from the driving current Id by a current amount of the bypass current Ibp distributed through the seventh transistor T7 may be provided to the light emitting element ED so that the black image is definitely represented. Thus, the pixel PXij may produce a precise black grayscale image by using the seventh transistors T7, and as a result, a contrast ratio may be improved.

Then, the j-th emission control signal EMj supplied from the j-th emission control line EMLj is changed from a high level to a low level. The fifth and sixth transistors T5 and T6 may be turned-on by the j-th emission control signal EMj having a low level. Then, the driving current Id according to a difference in voltage between the third electrode of the first transistor T1 and the first driving voltage ELVDD is generated, and the driving current Id is supplied to the light emitting element ED through the sixth transistor T6 so that the current Ied flows through the light emitting element ED.

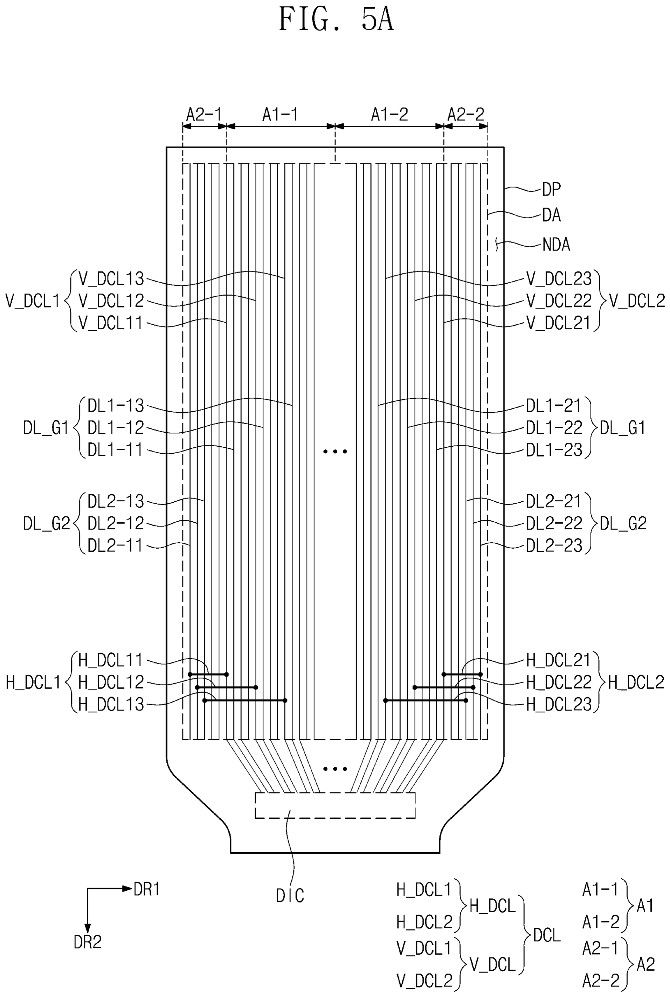

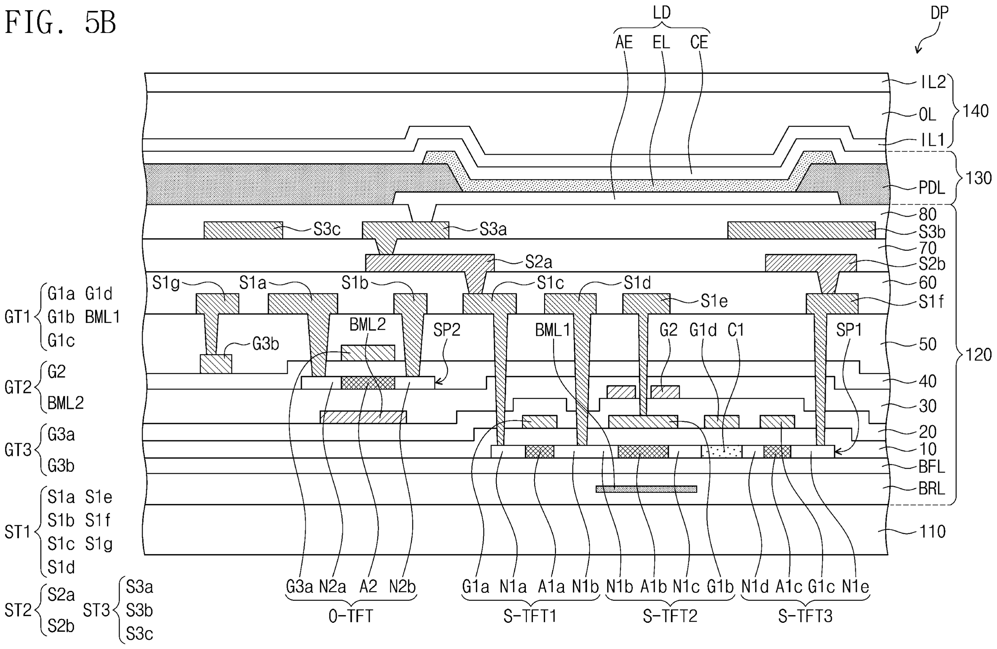

FIG. 5A illustrates a display panel in plan view, according to one or more embodiments. FIG. 5B illustrates a portion of an example display panel in a cross-sectional view, according to one or more embodiments. For convenience of description, FIG. 5A illustrates only some of data lines, and FIG. 5B illustrates a partial area in which the one pixel PXij illustrated in FIG. 4A is disposed.

Referring to FIG. 5A, a display panel DP may include a display area DA and a non-display area NDA. The non-display area NDA may surround the display area DA. A driving chip DIC may be disposed in the non-display area NDA. Pads defined at ends of the data lines DL1 to DLm (see FIG. 3) may be disposed in the area in which the driving chip DIC is disposed. In one or more embodiments, the driving chip DIC is illustrated as being mounted. However, in a non-limiting example, the area in which the driving chip DIC is disposed may be an area to which a separate circuit board is connected.

The data lines DL1 to DLm may be divided into a first group and a second group. The first group may include a plurality of first data lines DL_G1, and the second group may include a plurality of second data lines DL_G2. The first data lines DL_G1 may be arranged in the first direction DR1, and the second data lines DL_G2 may be arranged in the first direction DR1. The first data lines DL_G1 may be spaced apart from the second data lines DL_G2 in the first direction DR1.

The first data lines DL_G1 may be connected to a pixel driving circuit P_PD of a first group of pixels among pixels PX, and the second data lines DL_G2 may be connected to a pixel driving circuit P_PD of a second group of pixels among the pixels PX. The first group of pixels and the first data lines DL_G1 may be disposed in a first area A1, and the second group of pixels and the second data lines DL_G2 may be disposed in a second area A2. The first area A1 may include a (1-1)-th area A1-1 defined on a first side on the basis of a central line of the display panel DP, which is parallel to the second direction DR2, and a (1-2)-th area A1-2 defined on a second side on the basis of the central line. The second area A2 may include a (2-1)-th area A2-1 disposed between the (1-1)-th area A1-1 and the non-display area NDA, and a (2-2)-th area A2-2 disposed between the (1-2)-th area A1-2 and the non-display area NDA.

The first data lines DL_G1 may include (1-1)-th data lines DL1-11 to DL1-13 disposed in the (1-1)-th area A1-1, and (1-2)-th data lines DL1-21 to DL1-23 disposed in the (1-2)-th area A1-2. The (1-1)-th data lines DL1-11 to DL1-13 and the (1-2)-th data lines DL1-21 to DL1-23 may extend from the display area DA to the area in which the driving chip DIC is disposed. FIG. 5A illustrates a non-limiting example in which the (1-1)-th data lines DL1-11 to DL1-13 and the (1-2)-th data lines DL1-21 to DL1-23 are connected to one driving chip DIC. For example, the (1-1)-th data lines DL1-11 to DL1-13 and the (1-2)-th data lines DL1-21 to DL1-23 may be connected to different driving chips, respectively.

The second data lines DL_G2 may include (2-1)-th data lines DL2-11 to DL2-13 disposed in the (2-1)-th area A2-1, and (2-2)-th data lines DL2-21 to DL2-23 disposed in the (2-2)-th area A2-2. The second data lines DL_G2 may be lines which are disposed in the display area DA but do not extend to the area in which the driving chip DIC is disposed. That is, unlike the first data lines DL_G1, the second data lines DL_G2 may not be directly connected to the driving chip DIC but may be connected to the driving chip DIC through separate data connection lines DCL.

The data connection lines DCL may include a plurality of vertical data connection lines V_DCL extending along the first data lines DL_G1, and a plurality of horizontal data connection lines H_DCL extending in the first direction DR1.

The horizontal data connection lines H_DCL may include first horizontal data connection lines H_DCL11 to H_DCL13 and second horizontal data connection lines H_DCL21 to H_DCL23. The first horizontal data connection lines H_DCL11 to H_DCL13 may be connected to the (2-1)-th data lines DL2-11 to DL2-13, and the second horizontal data connection lines H_DCL21 to H_DCL23 may be connected to the (2-2)-th data lines DL2-21 to DL2-23. The vertical data connection lines V_DCL may include first vertical data connection lines V_DCL11 to V_DCL13 and second vertical data connection lines V_DCL21 to V_DCL23. The first vertical data connection lines V_DCL11 to V_DCL13 may be connected to the first horizontal data connection lines H_DCL11 to H_DCL13, and the second vertical data connection lines V_DCL21 to V_DCL23 may be connected to the second horizontal data connection lines H_DCL21 to H_DCL23.

Thus, the first vertical data connection lines V_DCL11 to V_DCL13 may be electrically connected to the (2-1)-th data lines DL2-11 to DL2-13 through the first horizontal data connection lines H_DCL11 to H_DCL13. The second vertical data connection lines V_DCL21 to V_DCL23 may be electrically connected to the (2-2)-th data lines DL2-21 to DL2-23 through the second horizontal data connection lines H_DCL21 to H_DCL23.

The first vertical data connection lines V_DCL11 to V_DCL13 and the (1-1)-th data lines DL1-11 to DL1-13 may be alternately and repeatedly arranged in the (1-1)-th area A1-1. The second vertical data connection lines V_DCL21 to V_DCL23 and the (1-2)-th data lines DL1-21 to DL1-23 may be alternately and repeatedly arranged in the (1-2)-th area A1-2. Here, at least two (1-1)-th data lines may be disposed between two first vertical data connection lines. Likewise, at least two (1-2)-th data lines may be disposed between two second vertical data connection lines. That is, according to one or more embodiments of the present disclosure, an arrangement shape of the data lines (e.g., at least two data lines located between nearest/adjacent vertical data connection lines) may be designed so that one vertical data connection line is disposed for a plurality of data lines. A distance between the vertical data connection lines V_DCL may be increased to increase a width of the first area A1 and prevent electrical interference between the vertical data connection lines V_DCL, thereby easily designing a high-resolution display panel.

A portion of the vertical data connection lines V_DCL and the horizontal data connection lines H_DCL may be disposed in the display area DA. That is, a portion of the data connection lines for connecting the second data lines DL_G2 to the driving chip DIC may be disposed in the display area DA. Thus, a surface area of an area occupied by the data connection lines in the non-display area NDA may be decreased, and as a result, a surface area of a dead space of the display panel DP may be decreased to achieve a borderless display panel DP.

In addition, according to one or more embodiments of the present disclosure, pixel units disposed in the second area A2 may be connected to different numbers of the vertical data connection lines and the data lines. That is, the number (K) of second data lines connected to one pixel unit including n sub-pixels may be more than or less than n/2, and the number of vertical data connection lines may be 1 or more and n-K. For example, when one pixel unit includes three pixels, only one vertical data connection line may be assigned to the pixel unit. Accordingly, the number of the vertical data connection lines connected to one pixel unit may be smaller than the number of the second data lines, thereby freely designing arrangement positions of the vertical data connection lines and easily designing the high-resolution display panel. Alternatively, for example, when one pixel unit includes four pixels, only one vertical data connection line may be assigned to the pixel unit, or three vertical data connection lines may be assigned to the one pixel unit. According to one or more embodiments of the present disclosure, the number of the vertical data connection lines connected to one pixel unit and the number of the data lines may be designed in various combinations, thereby improving a design degree of freedom of the pixel driving circuit.

According to one or more embodiments of the present disclosure, as the number of the data connection lines connected to one pixel unit may be designed to be smaller than the number of the data lines, a boundary between the first area A1 and the second area A2 may be biased outward from a center of the display panel DP, and a width of the area, in which the driving chip DIC is disposed, in the first direction DR1may be increased to increase an arrangement distance between the pads disposed in the area in which the driving chip DIC is disposed.

Referring to FIG. 5B, a display panel DP may include a base layer 110, a circuit layer 120, an element layer 130, and an encapsulation layer 140. The base layer 110 may include a synthetic resin layer. The synthetic resin layer may be a polyimide-based resin layer, and a material thereof is not particularly limited. In addition, the base layer 110 may include a glass substrate, a metal substrate, an organic/inorganic composite material substrate, or the like.

The circuit layer 120 may be disposed on the base layer 110. The circuit layer 120 may include a circuit element including a plurality of insulating layers and a plurality of conductive patterns. The circuit element may include a transistor, a capacitor, a signal line, and connection electrodes, as elements constituting the pixel driving circuit PDC (see FIG. 4A). As an example, FIG. 5B illustrates a silicon thin-film transistor S-TFT and an oxide thin-film transistor O-TFT in the pixel driving circuit PDC. However, all the transistors constituting the pixel driving circuit PDC may be silicon thin-film transistors S-TFT or may be oxide thin-film transistors O-TFT.

In one or more embodiments, the insulating layers are illustrated as including a lower insulating layer including a barrier layer BRL and a buffer layer BFL, and first to eighth insulating layers 10, 20, 30, 40, 50, 60, 70 and 80. In one or more embodiments, the first to fifth insulating layers 10, 20, 30, 40 and 50 stacked, in sequence, on the buffer layer BFL may be inorganic layers, and the sixth to eighth insulating layers 60 to 80 may be organic layers. However, this is illustrated as an example, and the number of the insulating layers constituting the circuit layer 120 may be variously changed and may not be limited to one or more embodiments.

The barrier layer BRL may be disposed on the base layer 110. The barrier layer BRL prevents foreign matter from being introduced into the circuit layer 120 from the outside. The barrier layer BRL may have a single-layer structure or a multilayer structure. The barrier layer BRL may include at least one of silicon oxide, silicon nitride, silicon oxynitride, or amorphous silicon.

The barrier layer BRL may further include a first lower light blocking layer BML1. For example, in a case in which the barrier layer BRL has a multilayer structure, the first lower light blocking layer BML1 may be disposed between layers constituting the barrier layer BRL. However, in a non-limiting example, the first lower light blocking layer BML1 may be disposed between the base layer 110 and the barrier layer BRL or disposed on the barrier layer BRL. The first lower light blocking layer BML1 may be omitted in one or more embodiments. The first lower light blocking layer BML1 may be referred to as a first lower layer, a first lower metal layer, a first lower electrode layer, a first lower shield layer, a first light blocking layer, a first metal layer, a first shield layer, or a first overlap layer.

The buffer layer BFL may be disposed on the barrier layer BRL. The buffer layer BFL may prevent a phenomenon in which metal atoms or impurities are spread from the base layer 110 to a first semiconductor pattern. In addition, the buffer layer BFL may adjust a heat supply rate during a crystallization process for forming the first semiconductor pattern so that the first semiconductor pattern is uniformly formed. In addition, the buffer layer BFL improves bonding force between the base layer 110 and the semiconductor pattern and/or the conductive pattern.

The buffer layer BFL may include a silicon oxide layer and/or a silicon nitride layer. The silicon oxide layer and the silicon nitride layer may be alternately stacked. Additionally, the buffer layer BFL is illustrated as having a single-layer structure, but in one or more embodiments, the buffer layer BFL may include a plurality of inorganic layers. For example, the buffer layer BFL may include a first sub-buffer layer including silicon nitride, and a second sub-buffer layer disposed on the first sub-buffer layer and including silicon oxide.

A first semiconductor pattern SP1 may be disposed on the buffer layer BFL. The first semiconductor pattern SP1 may include a silicon semiconductor. For example, the silicon semiconductor may include amorphous silicon, polycrystalline silicon, or the like. For example, the first semiconductor pattern SP1 may include low-temperature polysilicon.

FIG. 5B just illustrates a portion of the first semiconductor pattern SP1 disposed on the buffer layer BFL, and another portion of the first semiconductor pattern SP1 may be further disposed on another area. The first semiconductor pattern SP1 may be arranged over pixels according to a specific rule. The first semiconductor pattern SP1 may have different electrical properties according to whether the first semiconductor pattern SP1 is doped or not. The first semiconductor pattern SP1 may include a first region with high conductivity and a second region with low conductivity. The first region may be doped with an n-type dopant or a p-type dopant. A p-type transistor may include a doped region doped with the p-type dopant, and an n-type transistor may include a doped region doped with the n-type dopant. The second region may be a non-doped region, or a region doped at a lower concentration than the first region.

The conductivity of the first region may be higher than the conductivity of the second region, and the first region may substantially serve as an electrode or a signal line. The second region may substantially correspond to an active region (or channel) of a transistor. In other words, one portion of a semiconductor pattern may be an active region of the transistor, another portion thereof may be a source or a drain of the transistor, and still another portion thereof may be a connection electrode or a connection signal line.

The first semiconductor pattern SP1 illustrated in FIG. 5B may include nine sub-regions N1a, A1a, N1b, A1b, N1c, C1, N1d, A1c and N1e. A first sub-region N1a, a third sub-region N1b, a fifth sub-region N1c, a seventh sub-region N1d, and a ninth sub-region N1e may each be the first region having high conductivity, and a second sub-region A1a, a fourth sub-region A1b, and an eighth sub-region A1c may each be the second region having relatively low conductivity. A sixth sub-region C1 may be a doped region but doped at a different concentration from the second sub-region A1a, the fourth sub-region A1b, and the eighth sub-region A1c.

A first thin-film transistor S-TFT1 may include a first gate electrode G1a and a portion of the first semiconductor pattern SP1. The first sub-region N1a, the second sub-region A1a, the third sub-region N1b of the first semiconductor pattern SP1 may respectively function as a drain, a channel, and a source of the first thin-film transistor S-TFT1. Meanwhile, this is described as an example, and the first sub-region N1a, the second sub-region A1a, the third sub-region N1b may respectively function as the source, the channel, and the drain of the first thin-film transistor S-TFT1, and are not limited to one or more embodiments.

In one or more embodiments, the first thin-film transistor S-TFT1 may correspond to the sixth transistor T6 (see FIG. 4A). Thus, the first thin-film transistor S-TFT1 may be connected to a light emitting element LD through connection electrodes S1c, S2a and S3a. However, this is illustrated as an example, and the first thin-film transistor S-TFT1 may not be limited to one or more embodiments.

A second thin-film transistor S-TFT2 may include a second gate electrode G1b and a portion of the first semiconductor pattern SP1. The third sub-region N1b, the fourth sub-region A1b, the fifth sub-region N1c of the first semiconductor pattern SP1 may respectively function as a drain, a channel, and a source of the second thin-film transistor S-TFT2. The third sub-region N1b may be the source of the first thin-film transistor S-TFT1 and the drain of the second thin-film transistor S-TFT2. Meanwhile, this is described as an example, and the third sub-region N1b, the fourth sub-region A1b, the fifth sub-region N1c may respectively function as the source, the channel, and the drain of the second thin-film transistor S-TFT2, and are not limited to one or more embodiments.

Additionally, the second thin-film transistor S-TFT2 may correspond to the first transistor T1 (see FIG. 4A). The first lower light blocking layer BML1 may be connected to the first driving voltage ELVDD (see FIG. 4B). Alternatively, the first lower light blocking layer BML1 may be connected to the second gate electrode G1b of the second thin-film transistor S-TFT2, and thus the second thin-film transistor S-TFT2 may have a gate-sink structure. However, this is illustrated as an example, and the second thin-film transistor S-TFT2 may not be limited to one or more embodiments.

A third thin-film transistor S-TFT3 may include a third gate electrode G1c and a portion of the first semiconductor pattern SP1. The seventh sub-region N1d, the eighth sub-region A1c, the ninth sub-region N1e of the first semiconductor pattern SP1 may respectively function as a drain, a channel, and a source of the third thin-film transistor S-TFT3. Meanwhile, this is described as an example, and the seventh sub-region N1d, the eighth sub-region A1c, the ninth sub-region N1e may respectively function as the source, the channel, and the drain of the third thin-film transistor S-TFT3, and are not limited to one or more embodiments.

The third thin-film transistor S-TFT3 may correspond to the second transistor T2 (see FIG. 4A). That is, the third thin-film transistor S-TFT3 may be connected to the data line DLi (see FIG. 4A) through connection electrodes S1f and S2b and provide the data signal Di (see FIG. 4A) to a drain of the second transistor T2. However, this is illustrated as an example, and the third thin-film transistor S-TFT3 may not be limited to one or more embodiments.

The sixth sub-region C1 may be a doped region. The sixth sub-region C1 may be doped through a different process from the second sub-region A1a, the fourth sub-region A1b, and the eighth sub-region A1c, and may be a region doped at a different concentration. The sixth sub-region C1 may correspond to a third node N3 connected to the first transistor T1, the second transistor T2, the fifth transistor T5, and the eighth transistor T8. According to one or more embodiments of the present disclosure, the sixth sub-region C1 may be provided in the first semiconductor pattern SP1 so that a separate conductive pattern connected to the first semiconductor pattern SP1 so as to provide the third node N3 is omitted. Thus, the design of the pixel driving circuit PDC may be simplified, and the high-resolution display panel may be easily provided.

The sixth sub-region C1 may constitute a certain capacitor with a first gate conductive pattern G1d and the first insulating layer 10 therebetween. The capacitor may be a parasitic capacitor. However, this is described as an example, and the capacitor may be omitted according to a signal transmitted by the first gate conductive pattern G1d or an arrangement position of the first gate conductive pattern G1d, and may not be limited to one or more embodiments.

The first insulating layer 10 may be disposed on the buffer layer BFL. The first insulating layer 10 may cover the first semiconductor pattern SP1. The first insulating layer 10 may be an inorganic layer and/or an organic layer and have a single-layer or multilayer structure. The first insulating layer 10 may include at least one of aluminum oxide, titanium oxide, silicon oxide, silicon nitride, silicon oxynitride, zirconium oxide, or hafnium oxide. For example, the first insulating layer 10 may be a silicon oxide layer having a single-layer structure.

A first gate electrode layer GT1 is disposed on the first insulating layer 10. The first gate electrode layer GT1 may include the first gate electrode G1a, the second gate electrode G1b, the third gate electrode G1c, and the first gate conductive pattern G1d. Each of the first gate electrode G1a, the second gate electrode G1b, the third gate electrode G1c, and the first gate conductive pattern G1d may be a portion of a metal pattern. As described above, the first gate electrode G1a, the second gate electrode G1b, and the third gate electrode G1c may overlap the first semiconductor pattern SP1 in different areas, and provide the first to third thin-film transistors S-TFT1, S-TFT2 and S-TFT3. The first gate conductive pattern G1d may overlap the sixth sub-region C1 of the first semiconductor pattern SP1 and constitute a capacitor.

The first gate conductive pattern G1d may function as a mask in a process of doping the first semiconductor pattern SP1. Accordingly, the second sub-region A1a, the fourth sub-region A1b, and the eighth sub-region A1c which have surface areas and shapes corresponding to the first to third gate electrodes G1a, G1b and G1c constituting the first gate electrode layer GT1 may be provided. The first gate electrode layer GT1 may include titanium, silver, silver-containing alloy, molybdenum, molybdenum-containing alloy, aluminum, aluminum-containing alloy, aluminum nitride, tungsten, tungsten nitride, copper, indium tin oxide, indium zinc oxide, or the like, but is not particularly limited thereto.

The first gate electrode G1a, the second gate electrode G1b, the third gate electrode G1c, and the first gate conductive pattern G1d may be formed at the same time through the same process using the same material. However, this is described as an example, and the first gate electrode G1a, the second gate electrode G1b, the third gate electrode G1c, and the first gate conductive pattern G1d may include different materials or be separately formed through different processes, and are not limited to one or more embodiments.

The second insulating layer 20 may be disposed on the first insulating layer 10 and cover the first gate electrode layer GT1. The second insulating layer 20 may be an inorganic layer and may have a single-layer or multilayer structure. The second insulating layer 20 may include at least one of silicon oxide, silicon nitride, or silicon oxynitride. Additionally, the second insulating layer 20 may have a single-layer structure including a silicon nitride layer.

A second gate electrode layer GT2 may be disposed on the second insulating layer 20. FIG. 5B illustrates a second lower light blocking layer BML2 and a second gate conductive pattern G2 of the second gate electrode layer GT2. Each of the second lower light blocking layer BML2 and the second gate conductive pattern G2 may be a portion of a conductive pattern. The second lower light blocking layer BML2 and the second gate conductive pattern G2 may be formed at the same time through the same process using the same material. However, this is described as an example, and the second lower light blocking layer BML2 and the second gate conductive pattern G2 may include different materials or be separately formed through different processes, and are not limited to one or more embodiments.

The second gate conductive pattern G2 may include a capacitor with the second insulating layer 10 and the second gate electrode G1b of the first gate electrode layer GT1 there between. For example, the second thin-film transistor S-TFT2 may correspond to the first transistor T1 (see FIG. 4A) illustrated in FIG. 4A, and the second gate conductive pattern G2 may be an electrode which constitutes the second gate electrode G1b and a storage capacitor Cst (see FIG. 4A).

The third insulating layer 30 may be disposed on the second insulating layer 20. The third insulating layer 30 may cover the second gate electrode layer GT2. The third insulating layer 30 may be an inorganic layer and may have a single-layer or multilayer structure. For example, the third insulating layer 30 may have a multilayer structure including a silicon oxide layer and a silicon nitride layer.

A second semiconductor pattern SP2 may be disposed on the third insulating layer 30. The second semiconductor pattern SP2 may include an oxide semiconductor. The oxide semiconductor may include a plurality of regions divided according to whether a metal oxide is reduced or not. A region in which the metal oxide is reduced (hereinafter referred to as a reduced region) may have a higher conductivity than a region in which the metal oxide is not reduced (hereinafter referred to as a non-reduced region). The reduced region may substantially serve as a source/drain or a signal line of a transistor. The non-reduced region may substantially correspond to an active region (or a semiconductor region or channel) of the transistor. The second semiconductor pattern SP2 may include a plurality of reduced regions N2a and N2b (hereinafter referred to as a first reduced region N2a and a second reduced region N2b), and a non-reduced region A2.

The oxide thin-film transistor O-TFT may be disposed on the third insulating layer 30. The oxide thin-film transistor O-TFT may include a fourth gate electrode G3a and the second semiconductor pattern SP2. The first reduced region N2a, the non-reduced region A2, the second reduced region N2b of the second semiconductor pattern SP2 may respectively function as a drain, a channel, and a source of the oxide thin-film transistor O-TFT. Meanwhile, this is described as an example, and the first reduced region N2a, the non-reduced region A2, the second reduced region N2b may respectively function as the source, the channel, and the drain of the oxide thin-film transistor O-TFT, and are not limited to one or more embodiments.

A third gate electrode layer GT3 may be disposed on the third insulating layer 30. FIG. 5B illustrates the fourth gate electrode G3a and a third gate conductive pattern G3b of the third gate electrode layer GT3.

As described above, the fourth gate electrode G3a may overlap the second semiconductor pattern SP2 and function as a gate of the oxide thin-film transistor O-TFT. The fourth gate electrode G3a overlaps an active area A2. The fourth gate electrode G3a may function as a mask in a process of reducing the second semiconductor pattern SP2. Accordingly, the non-reduced region A2 may have a surface area and a shape corresponding to the fourth gate electrode G3a.

The third gate conductive pattern G3b may be a signal line. The third gate conductive pattern G3b may be connected to at least one of circuit elements constituting the pixel driving circuit PDC and transmit an electrical signal. Alternatively, the third gate conductive pattern G3b may constitute any one of the circuit elements constituting the pixel driving circuit PDC and may not be limited to one or more embodiments.

Each of the fourth gate electrode G3a and the third gate conductive pattern G3b may be a portion of a conductive pattern. The third gate electrode layer GT3 may include titanium, silver, silver-containing alloy, molybdenum, molybdenum-containing alloy, aluminum, aluminum-containing alloy, aluminum nitride, tungsten, tungsten nitride, copper, indium tin oxide, indium zinc oxide, or the like, but is not particularly limited thereto. The fourth gate electrode G3a and the third gate conductive pattern G3b may be formed at the same time through the same process using the same material. However, this is described as an example, and the fourth gate electrode G3a and the third gate conductive pattern G3b may include different materials or be separately formed through different processes, and are not limited to one or more embodiments.

The fourth insulating layer 40 may be disposed on the third insulating layer 30. The fourth insulating layer 40 may cover the second semiconductor pattern SP2. The fourth insulating layer 40 may be an inorganic layer and may have a single-layer or multilayer structure. The fourth insulating layer 40 may include at least one of aluminum oxide, titanium oxide, silicon oxide, silicon nitride, silicon oxynitride, zirconium oxide, or hafnium oxide. Additionally, the fourth insulating layer 40 may have a single-layer structure including silicon oxide.

A gate electrode G3a of the oxide thin-film transistor O-TFT may be disposed on the fourth insulating layer 40. The gate electrode G3a may be a portion of a metal pattern. The gate electrode G3a overlaps the active area A2. The gate electrode G3a may function as a mask in the process of reducing the second semiconductor pattern.

The second lower light blocking layer BML2 may be disposed below the oxide thin-film transistor O-TFT. The second lower light blocking layer BML2 may be disposed between the second insulating layer 20 and the third insulating layer 30. The second lower light blocking layer BML2 may include the same material as one electrode Csta constituting a capacitor and be formed through the same process.

The fifth insulating layer 50 may be disposed on the fourth insulating layer 40 and cover the third gate electrode GT3. A first source electrode layer ST1 may be disposed on the fifth insulating layer 50. As an example, FIG. 5B illustrates first to seventh connection electrodes S1a, S1b, S1c, S1d, S1e, S1f and S1g among components of the first source electrode layer ST1. Each of the first to seventh connection electrodes S1a, S1b, S1c, S1d, S1e, S1f and S1g may be a conductive pattern. Each of the first to seventh connection electrodes S1a, S1b, S1c, S1d, S1e, S1f and S1g may pass through the lower insulating layer and be connected to other conductive pattern or semiconductor pattern.

Each of the first connection electrode S1a and the second connection electrode S1b may pass through the fourth and fifth insulating layers 40 and 50 and be connected to the second semiconductor pattern SP2. The first connection electrode S1a may be connected to the first reduced region N2a and transmit a signal to the drain of the oxide thin-film transistor O-TFT, and the second connection electrode S1b may be connected to the second reduced region N2b and transmit a signal to the source of the oxide thin-film transistor O-TFT.

Each of the third connection electrode S1c and the fourth connection electrode S1d may pass through the first to fifth insulating layers 10, 20, 30, 40 and 50 and be connected to the first semiconductor pattern SP1. The third connection electrode S1c may be connected to the first sub-region N1a and transmit a signal to the drain of the first thin-film transistor S-TFT1, and the fourth connection electrode S1d may be connected to the third sub-region N1b and transmit a signal to the source of the first thin-film transistor S-TFT1.

The fifth connection electrode S1c may pass through the second to fifth insulating layers 20, 30, 40 and 50 and be connected to the second gate electrode G1b. Here, a certain through-hole may be defined in the second gate conductive pattern G2 so that the second gate conductive pattern G2 overlapping the second gate electrode G1b is not shortcircuited to the fifth connection electrode S1e. Accordingly, the second gate conductive pattern G2 and the second gate electrode G1b together may stably constitute a capacitor without a short-circuit to the fifth connection electrode S1e.

The sixth connection electrode S1f may pass through the first to fifth insulating layers 10, 20, 30, 40 and 50 and be connected to the first semiconductor pattern SP1. The sixth connection electrode S1f may be connected to the ninth sub-region N1e and transmit a signal to the source of the third thin-film transistor S-TFT3.

The seventh connection electrode S1g may pass through the fifth insulating layer 50 and be connected to the third gate conductive pattern G3b. The seventh connection electrode S1g may be a signal line which provides a certain electrical signal to the third gate conductive pattern G3b, but may not be limited thereto.

The sixth insulating layer 60 may be disposed on the fifth insulating layer 50 and cover the first source electrode layer ST1. A second source electrode layer ST2 may be disposed on the sixth insulating layer 60. As an example, FIG. 5B illustrates eighth and ninth connection electrodes S2a and S2b among components of the second source electrode layer ST2. Each of the eighth and ninth connection electrodes S2a and S2b may be a conductive pattern. Each of the eighth and ninth connection electrodes S2a and S2b may pass through the lower insulating layer and be connected to another conductive pattern.

The eighth connection electrode S2a may pass through the sixth insulating layer 60 and be connected to the third connection electrode S1c. The ninth connection electrode S2b may pass through the sixth insulating layer 60 and be connected to the sixth connection electrode S1f. In a non-limiting example, the ninth connection electrode S2b may be a signal line which provides a signal to the source of the third thin-film transistor S-TFT3 through the sixth connection electrode S1f, and may be, for example, the data line DLi (see FIG. 4A).

The seventh insulating layer 70 may be disposed on the sixth insulating layer 60 and cover the second source electrode layer ST2. A third source electrode layer ST3 may be disposed on the seventh insulating layer 70. As an example, FIG. 5B illustrates a tenth connection electrode S3a, a first source conductive pattern S3b, and a second source conductive pattern S3c among components of the third source electrode layer ST3. Each of the tenth connection electrode S3a, the first source conductive pattern S3b, and the second source conductive pattern S3c may be a conductive pattern. Each of the tenth connection electrode S3a, the first source conductive pattern S3b, and the second source conductive pattern S3c may pass through the lower insulating layer and be connected to other conductive pattern or may not pass therethrough, and may not be limited to one or more embodiments.

The tenth connection electrode S3a may pass through the seventh insulating layer 70 and be connected to the eighth connection electrode S2a. The tenth connection electrode S3a may be connected to the first thin-film transistor S-TFT1 through the eighth connection electrode S2a and the third connection electrode S1c, and connect the first thin-film transistor S-TFT1 to the light emitting element LD to be described later.

The first source conductive pattern S3b may overlap the ninth connection electrode S2b in a plane view. The first source conductive pattern S3b may electrically shield the ninth connection electrode S2b from the light emitting element LD, particularly to an anode electrode AE. The first source conductive pattern S3b may receive a constant voltage. For example, an eleventh connection electrode S3b may receive the first driving voltage ELVDD (see FIG. 4A). However, this is described as an example, and the first source conductive pattern S3b may receive the second driving voltage ELVSS (see FIG. 4A), the first initialization voltage Vint (see FIG. 4A), the second initialization voltage Vaint (see FIG. 4A), or the bias voltage Vbias (see FIG. 4A), and may not be limited to one or more embodiments.

The second source conductive pattern S3c is arranged to be spaced apart from the tenth connection electrode S3a and the first source conductive pattern S3b. The second source conductive pattern S3c may be one of the vertical data connection lines V_DCL (see FIG. 5A). The second source conductive pattern S3c may be connected to a corresponding data line of the first data lines DL_G1 (see FIG. 5A) through the horizontal data connection lines H_DCL (see FIG. 5A) which are not illustrated.

Additionally, the vertical data connection lines V_DCL may be disposed at different layer from the data lines DL_G1 and DL_G2 and disposed between the data lines DL_G1 and DL_G2 and the light emitting element LD. Accordingly, a design restriction for the vertical data connection lines V_DCL to circumvent the anode electrode AE or the data lines DL_G1 and DL_G2 may be eased. Thus, a design degree of freedom of the circuit layer 120 may be improved.

The eighth insulating layer 80 may be disposed on the seventh insulating layer 70. The eighth insulating layer 80 may cover the third source electrode layer ST3. Each of the sixth insulating layer 60, the seventh insulating layer 70, and the eighth insulating layer 80 may be an organic layer. For example, each of the sixth insulating layer 60, the seventh insulating layer 70, and the eighth insulating layer 80 may include a general purpose polymer such as benzocyclobutene (BCB), polyimide, hexamethyldisiloxane (HMDSO), polymethylmethacrylate (PMMA), or polystyrene (PS), a polymer derivative having a phenol-based group, an acrylic polymer, an imide-based polymer, an acryl ether-based polymer, an amide-based polymer, a fluorine-based polymer, a p-xylene-based polymer, a vinyl alcohol-based polymer, or a blend thereof.

The element layer 130 may be disposed on the eighth insulating layer 80. The element layer 130 may include a pixel defining film PDL and the light emitting element LD. The light emitting element LD may include a first electrode AE, an emission layer EL, and a second electrode CE. The first electrode AE may be referred to as a pixel electrode or an anode, and the second electrode CE may be referred to as a common electrode or a cathode.

The first electrode AE may be disposed on the eighth insulating layer 80. The first electrode AE may pass through the eighth insulating layer 80 and be connected to the tenth connection electrode S3a of the third source electrode layer ST3. The first electrode AE may be connected to the first thin-film transistor S-TFT1 through the tenth connection electrode S3a, the eighth connection electrode S2a, and the third connection electrode S1c. Meanwhile, at least one of the tenth connection electrode S3a, the eighth connection electrode S2a, or the third connection electrode S1c may be omitted, and in this case, the light emitting element LD and the first thin-film transistor S-TFT1 may be connected to each other by the remaining connection electrodes and are not limited to any one or more embodiments.

The first electrode AE may be a (semi-)transmissive electrode or a reflective electrode. According to one or more embodiments, the first electrode AE may include a reflective layer including silver, magnesium, aluminum, platinum, palladium, gold, nickel, neodymium, iridium, chromium, a compound thereof, or the like, and a transparent or semitransparent electrode layer provided on the reflective layer. The transparent or semitransparent electrode layer may include at least one selected from the group consisting of indium tin oxide, indium zinc oxide, indium gallium zinc oxide, zinc oxide or indium oxide, and aluminum-doped zinc oxide. For example, the first electrode AE may have a multilayer structure in which indium tin oxide, silver, and indium tin oxide are stacked in sequence.

Additionally, the vertical data connection lines V_DCL may be designed to be disposed at a position non-overlapping the first electrode AE. As described above, the vertical data connection lines V_DCL assigned to one pixel unit may be decreased in number and be disposed on the third source electrode layer ST3, unlike the data lines. Accordingly, the vertical data connection lines V_DCL may be designed for avoidance of the data lines or the first electrode AE, thereby improving the design degree of freedom thereof and improving electrical reliability of the display panel.

The pixel defining film PDL may be disposed on the eighth insulating layer 80. The pixel defining film PDL may have a light absorbing property, and, for example, the pixel defining film PDL may have a black color. The pixel defining film PDL may include a black component (a black coloring agent). The black component may include a black dye or a black pigment. The black component may include a carbon black, a metal such as chrome, or an oxide thereof.

An opening which exposes a portion of the first electrode AE may be defined in the pixel defining film PDL. That is, the pixel defining film PDL may cover an edge of the first electrode EL1. An emission area may be defined by the pixel defining film PDL.

The emission layer EL may be disposed on the first electrode AE and disposed in an area corresponding to the opening of the pixel defining film PDL. The pixel defining film PDL may include an insulating material and may include, for example, an organic insulating material. Meanwhile, the pixel defining film PDL may further have a light absorbing property, and, for example, the pixel defining film PDL may have a black color. Here, the pixel defining film PDL may further include a black component (a black coloring agent). The black component may include a black dye or a black pigment. The black component may include a carbon black, a metal such as chrome, or an oxide thereof.

The emission layer EL may include an organic material, an inorganic material, or an organic-inorganic material, each of which emits light of a certain color. Additionally, the emission layer EL may be patterned to be disposed in the opening defined in the pixel defining film PDL. The emission layer EL may be formed through a solution process or a deposition process. Meanwhile, the emission layer EL may be provided as a layer having a shape of one body to the entirety of the display panel. Here, light emitting elements constituting each pixel may emit light of the same color, or light of a different color may be displayed in each pixel through a color conversion layer to be further included.

The second electrode CE may be disposed on the emission layer EL. The second electrode CE may be disposed in the display area DA. Meanwhile, the light emitting element LD may further include a hole functional layer disposed between the first electrode AE and the emission layer EL, or further include an electron functional layer disposed between the second electrode CE and the emission layer EL. The functional layer may include an injection layer, a transport layer, or a blocking layer.

Meanwhile, the element layer 130 may further include a capping layer (not illustrated) and/or a low refractive layer disposed on the second electrode CE. The capping layer may serve to improve luminance efficiency by a principle of constructive interference. The capping layer may include, for example, a material having a refractive index of about 1.6 or more for light having a wavelength of about 589 nm. The capping layer may be an organic capping layer including an organic material, an inorganic capping layer including an inorganic material, or a composite capping layer including an organic material and an inorganic material. For example, the capping layer may include carbocyclic compounds, heterocyclic compounds, amine group-containing compounds, porphine derivatives, phthalocyanine derivatives, naphthalocyanine derivatives, alkali metal complexes, alkali earth metal complexes, or any combination thereof. The carbocyclic compounds, the heterocyclic compounds, the amine group-containing compounds may be selectively substituted with a substituent including oxygen (O), nitrogen (N), sulfur (S), selenium (Se), silicon (Si), fluorine (F), chlorine (Cl), bromine (Br), iodine (I), or any combination thereof. The low refractive layer may include lithium fluoride. The low refractive layer may be formed by a thermal evaporation method.

The encapsulation layer 140 may be disposed on the element layer 130. The encapsulation layer 140 may include a first inorganic encapsulation layer IL1, an organic encapsulation layer OL, and a second inorganic encapsulation layer IL2 which are stacked in sequence. The first and second inorganic encapsulation layers IL1 and IL2 may protect the element layer 130 from moisture and oxygen, and the organic encapsulation layer OL may protect the element layer 130 from foreign matter such as particles.

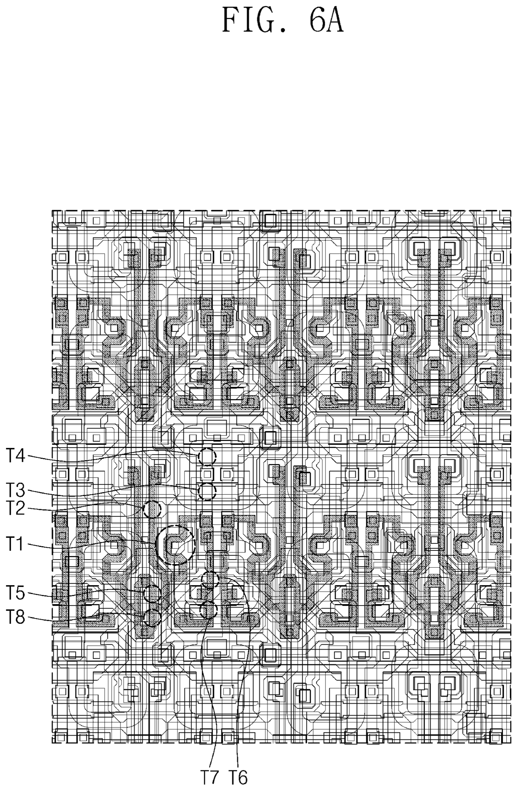

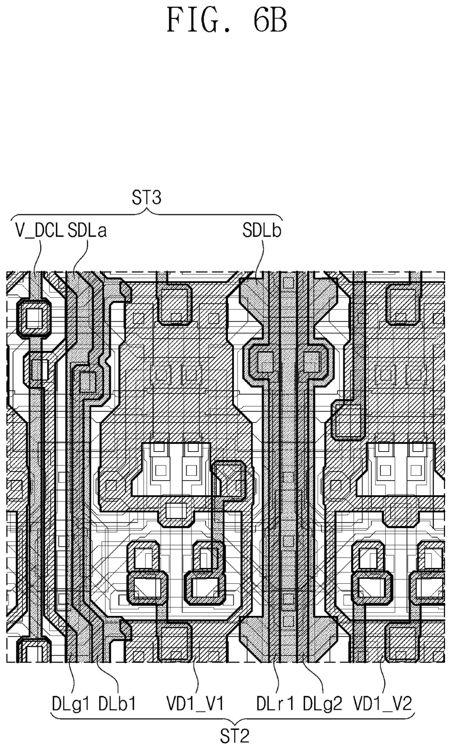

FIGS. 6A and 6B each illustrates one or more portions of an example display panel in a magnified plan view, according to one or more embodiments. FIG. 6A illustrates plan view of the circuit layer 120 (see FIG. 5B) and illustrates a first semiconductor pattern SP1 by shading. FIG. 6B illustrates an enlarged view of a portion in FIG. 6A.

Referring to FIG. 6A, first to eighth transistors T1, T2, T3, T4, T5, T6, T7 and T8 of a pixel driving circuit PDC may be arranged to be spaced apart from each other in plan view. Each of the first transistor T1, the second transistor T2, the fifth transistor T5, the sixth transistor T6, the seventh transistor T7, and the eighth transistor T8 may be provided along one first semiconductor pattern SP1 having a shape of one body. Thus, each of the first transistor T1, the second transistor T2, the fifth transistor T5, the sixth transistor T6, the seventh transistor T7, and the eighth transistor T8 may be a transistor including a silicon semiconductor.

The third transistor T3 and the fourth transistor T4 may be arranged to be spaced apart from the first semiconductor pattern SP1 in plan view. Each of the third transistor T3 and the fourth transistor T4 may be provided in a second semiconductor pattern SP2. That is, each of the third transistor T3 and the fourth transistor T4 may be a transistor including an oxide semiconductor.

The first transistor T1 may be provided in a portion of the first semiconductor pattern SP1, which has a bent shape. Additionally, the bent shape may be a shape that is convex or concave toward a horizontal direction. The second transistor T2 may be provided in a portion of the first semiconductor pattern SP1, which has a shape of a straight line extending in a vertical direction, and may be disposed on an upper left side on the basis of the first transistor T1.

The third transistor T3 may be disposed at a position non-overlapping the first semiconductor pattern SP1 and may be provided in the second semiconductor pattern SP2 (see FIG. 5B). The third transistor T3 may be disposed on an upper right side on the basis of the first transistor T1 and the second transistor T2.

The fourth transistor T4 may be disposed at a position non-overlapping the first semiconductor pattern SP1 and may be provided in the second semiconductor pattern SP2. The fourth transistor T4 may be spaced apart from the third transistor T3 and disposed on an upper side of the third transistor T3.

The fifth transistor T5 may be provided in a partial area of the first semiconductor pattern SP1. The fifth transistor T5 may be disposed on a lower left side on the basis of the first transistor T1 and may be disposed on a lower side of the second transistor T2.

The sixth transistor T6 may be provided in a portion of the first semiconductor pattern SP1, which has a shape of a straight line extending in the vertical direction. The sixth transistor T6 may be disposed on a lower right side on the basis of the first transistor T1 and may be disposed on a right side of the fifth transistor T5.

The seventh transistor T7 may be provided in a portion of the first semiconductor pattern SP1, which has a shape of a straight line extending in the vertical direction. The seventh transistor T7 may be disposed right below the sixth transistor T6. A portion of the first semiconductor pattern SP1 may have a shape passing the seventh transistor T7 and then bent in the horizontal direction.

The eighth transistor T8 may be disposed right below the fifth transistor T5 and may be disposed on a left side of the seventh transistor T7. Meanwhile, the shapes of the conductive patterns or the shapes of the semiconductor patterns and the arrangement of the elements, which are illustrated in FIG. 6A, are just illustrated as one or more embodiments, but may be variously modified and are non-limiting examples.

Referring to FIG. 6B, each of a second source electrode layer ST2 and a third source electrode layer ST3 may include a plurality of conductive patterns. The second source electrode layer ST2 and the third source electrode layer ST3 may be shaded in different colors so as to be easily distinguished.

The second source electrode layer ST2 may include data lines DLg1, DLb1, DLrl and DLg2 and constant voltage lines VDL1 and VDL2. The data lines DLg1, DLb1, DLrl and DLg2 may include four data lines DLg1, DLb1, DLrl and DLg2 arranged in a horizontal direction. The data lines DLg1, DLb1, DLr1 and DLg2 may include a first sub-data line DLg1, a second sub-data line DLb1, a third sub-data line DLrl, and a fourth sub-data line DLg2, respectively. The first to fourth sub-data lines DLg1, DLb1, DLrl and DLg2 may be connected to different pixels. For example, the first sub-data line DLg1 may be connected to a first pixel which displays a green color, the second sub-data line DLb1 may be connected to a second pixel which displays a blue color, the third sub-data line DLrl may be connected to a third pixel which displays a red color, and the fourth sub-data line DLg2 may be connected to a fourth pixel which displays a green color. The first to third pixels may constitute one emission unit, and the fourth pixel may constitute another emission unit. Alternatively, the first to fourth pixels may constitute one emission unit and are not limited to one or more embodiments.

Vertical first driving voltage lines VL1_V1 and VL1_V2 may be arranged not to overlap the first to fourth sub-data lines DLg1, DLb1, DLrl and DLg2 on a plane. Additionally, the vertical first driving voltage lines VL1_V1 and VL1_V2 may be lines which transmit the same constant voltage. Accordingly, the vertical first driving voltage lines VL1_V1 and VL1_V2 may have similar shapes.

Each of the vertical first driving voltage lines VL1_V1 and VL1_V2 may be designed in a shape having a relatively large surface area compared to the first to fourth sub-data lines DLg1, DLb1, DLrl and DLg2. The resistance of the vertical first driving voltage lines VL1_V1 and VL1_V2 may be decreased to uniformly provide a constant voltage to the pixels.

Each of the vertical first driving voltage lines VL1_V1 and VL1_V2 may provide the constant voltage to the pixels. For example, each of the vertical first driving voltage lines VL1_V1 and VL1_V2 may provide a first driving voltage ELVDD to each of the pixels. However, this is described as an example, and the vertical first driving voltage lines VL1_V1 and VL1_V2 may be lines which provide different constant voltages, may be lines which provide a constant voltage other than the first driving voltage ELVDD, and are not limited to one or more embodiments.

The third source electrode layer ST3 may include a vertical data connection line V_DCL and shield patterns SLDa and SLDb. The vertical data connection line V_DCL may extend in the second direction DR2 and include a contact portion. A data connection line DCL may be connected to a horizontal data connection line H_DCL constituting a first source electrode layer ST1 and be connected to a corresponding data line. The vertical data connection line V_DCL may be connected, through the horizontal connection line H_DCL, to one corresponding data line of data lines disposed in the second area A2 (see FIG. 5A), among the data lines DLg1, DLb1, DLr1 and DLg2 disposed in the second source electrode layer ST2. The vertical data connection line V_DCL may be disposed at a different layer from the third source electrode layer ST3, and thus may be disposed at a partially overlapping position in plan view without being affected by the arrangement of the data lines DLg1, DLb1, DLrl and DLg2 which are not connected. Thus, a design degree of freedom of the data connection line DCL may be improved.

The shield patterns SLDa and SLDb may be arranged to be spaced apart from the vertical data connection line DCL in plan view. Each of the shield patterns SLDa and SLDb may transmit a constant voltage. For example, each of the shield patterns SLDa and SLDb may transmit the first driving voltage ELVDD. However, this is described as an example, and the shield patterns SLDa and SLDb may transmit different constant voltages, may provide a constant voltage other than the first driving voltage ELVDD, and are not limited to one or more embodiments.

The shield patterns SLDa and SLDb may be disposed while overlapping the data lines DLg1, DLb1, DLrl and DLg2 in plan view. The shield patterns SLDa and SLDb may prevent an electrical signal transmitted to the data lines DLg1, DLb1, DLr1 and DLg2 from generating electrical interference in an element disposed on the third source electrode layer ST3. For example, when light emitting elements are arranged along the third and fourth sub-data lines DLrl and DLg2, a second shield pattern SLDb overlapping the third and fourth sub-data lines DLrl and DLg2 may function as a shield electrode which electrically shields the third and fourth sub-data lines DLr1 and DLg2 from the light emitting elements.

According to one or more embodiments of the present disclosure, as the third source electrode layer ST3 including the vertical data connection line V_DCL and the shield electrodes is provided, the design degree of freedom of the data connection line DCL may be improved and the high-resolution display panel in which the density of the data lines DLg1, DLb1, DLrl and DLg2 is high may be stably provided. Moreover, the electrical interference which may be generated by the data lines DLg1, DLb1, DLrl and DLg2 may be stably prevented through the shield electrode. Thus, an electronic apparatus with improved electrical reliability may be provided.

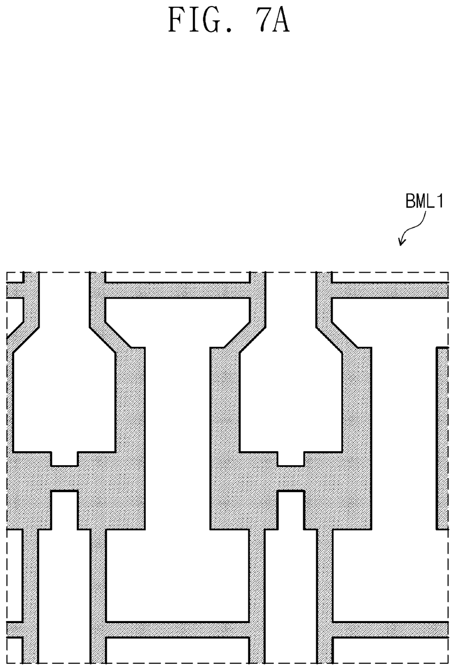

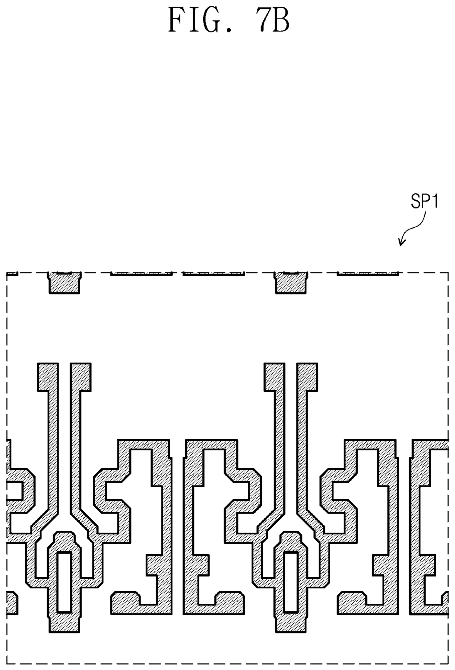

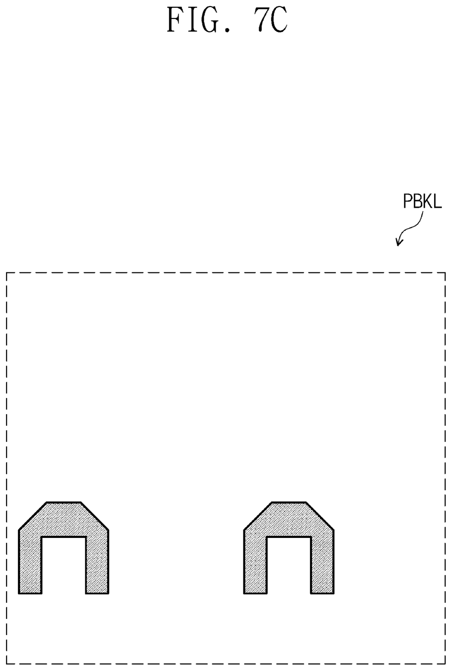

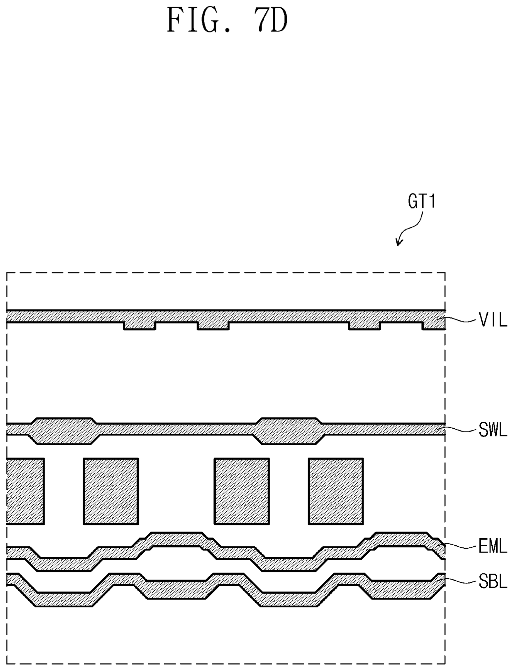

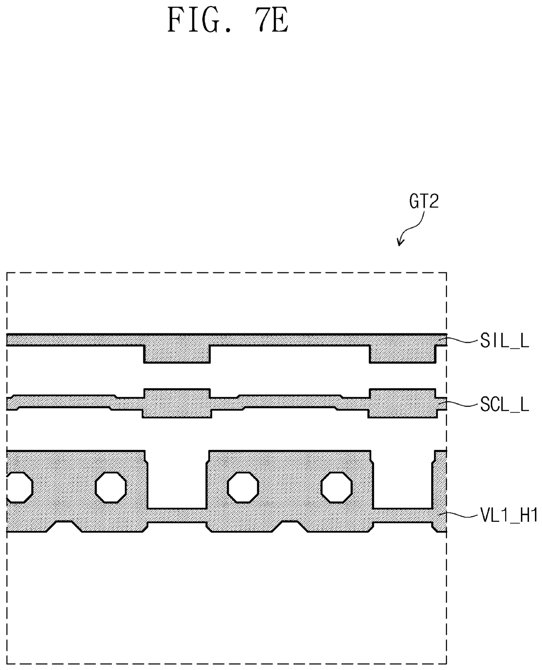

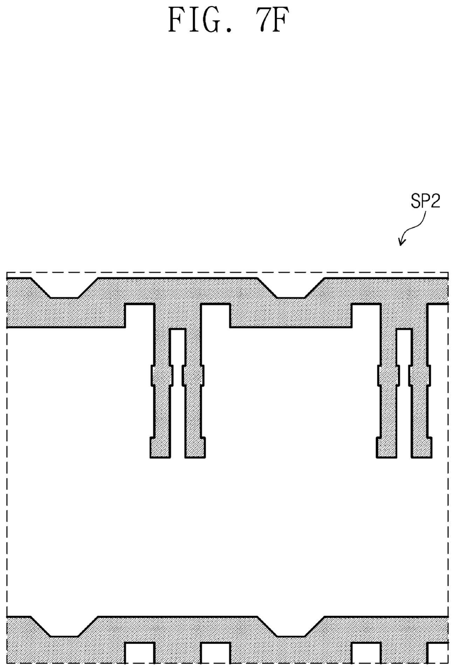

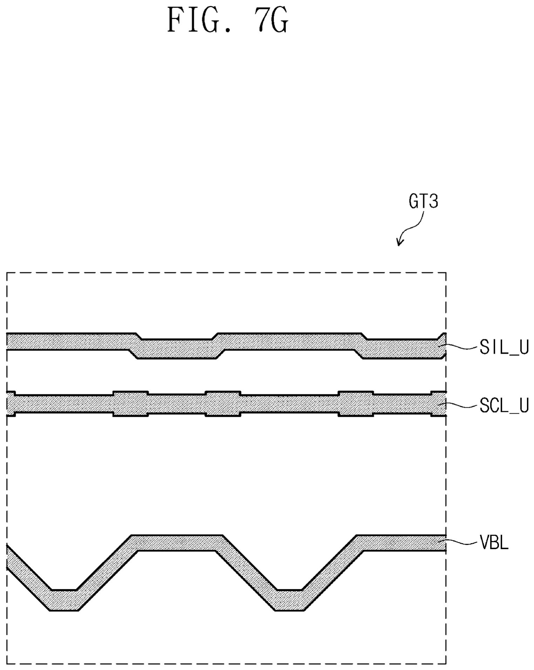

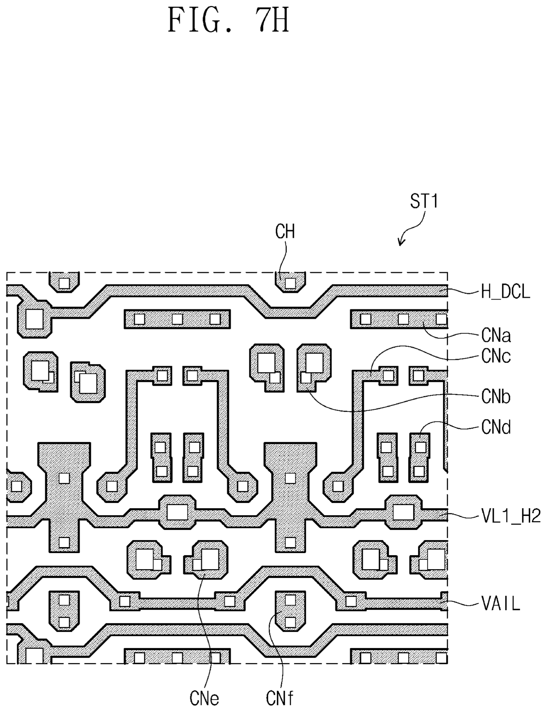

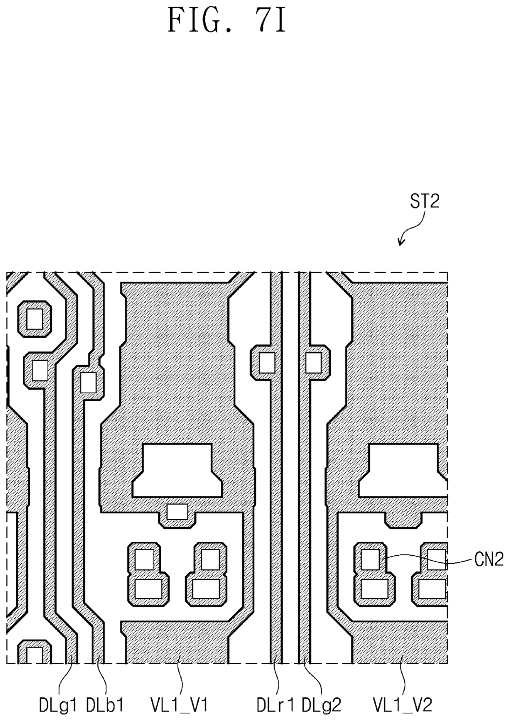

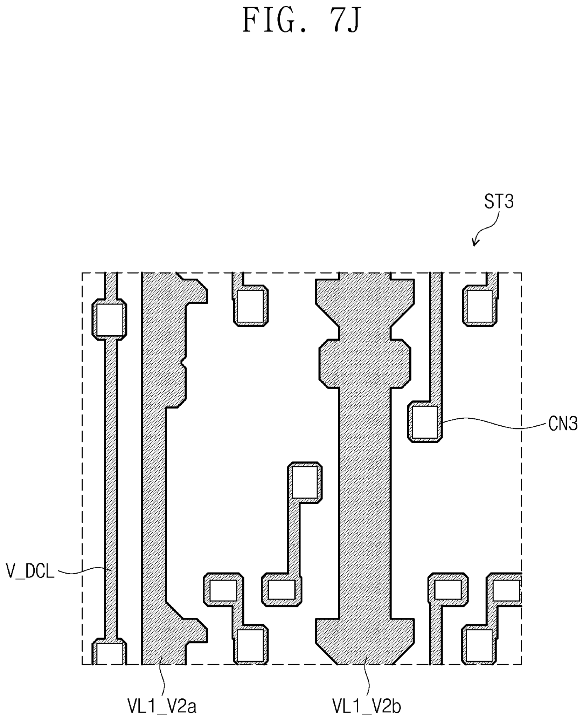

FIGS. 7A, 7B, 7C, 7D, 7E, 7F, 7G, 7H, 7I, and 7J each illustrates an example display panel, in various plan views, according to one or more embodiments. FIGS. 7A to 7J illustrate layers of the circuit layer 120 (see FIG. 5B) in stacking order, except for the insulating layers. One or more embodiments of the present disclosure may be described with reference to FIGS. 7A-7J and be described mainly on elements constituting one pixel driving circuit PDC (see FIG. 4A). Components that are the same as or similar to those described in FIGS. 1-6B may be designated with the same or similar reference numerals. Redundant descriptions of these components may be omitted.

Referring to FIG. 7A, a first lower light blocking layer BML1 may be provided as one conductive pattern layer having a shape of one body, in which a plurality of openings are defined. Additionally, two kinds of shapes of the openings may be alternately arranged in a horizontal direction. For example, openings each having a first shape may be continuously arranged with a predetermined spacing in a vertical direction to constitute one column. In addition, openings each having a second shape may bealso continuously arranged with a predetermined spacing in the vertical direction to constitute one column. The column in which the openings having the first shapes may bearranged, and the column in which the openings having the second shapes are arranged, may be alternately arranged in sequence in the horizontal direction. Here, in the horizontal direction, one opening having the first shape may overlap two openings having the second shapes, and one opening having the second shape may be arranged to overlap two openings having the second shapes. However, this is illustrated as an example, and the first lower light blocking layer BML1 may be designed in various shapes according to the design of the pixel driving circuit PDC and may not be limited to one or more embodiments.

Referring to FIG. 7B, a first semiconductor pattern SP1 may be provided while having a bent portion in plain view. The shapes of the openings of the first lower light blocking layer BML1 may be substantially designed in light of a shape of the first semiconductor pattern SP1. Additionally, the first semiconductor pattern SP1 may be designed to have a shape in which a portion P1 having a horizontally bent shape overlaps the first lower light blocking layer BML1 and the other portions overlap the openings of the first lower light blocking layer BML1. The portion P1 overlapping the first lower light blocking layer BML1 may correspond to a position of the first transistor T1 illustrated in FIG. 6A. The other transistors T2 to T8 illustrated in FIG. 6A may be provided at a position non-overlapping the first lower light blocking layer BML1.

Referring to FIG. 7C, a first doping process may be performed on the first semiconductor pattern SP1. A block pattern PBLK illustrated in FIG. 7C is a region into which a dopant is injected, and may overlap a portion of the first semiconductor pattern SP1. A region, which overlaps the block pattern PBLK, of the first semiconductor pattern SP1 may be doped and formed as the sixth sub-region C1 (see FIG. 5B). Two block patterns PBLK may correspond to sixth sub-regions C1 of different pixel driving circuits PDC, respectively. As described above, the sixth sub-region C1 may function as a third node N3. Thus, a plurality of transistors T1, T2, T5 and T8 may be connected through the sixth sub-region C1, and a separate connection electrode for connecting these transistors may be omitted to easily design the high-resolution display panel.

Thereafter, referring to FIG. 7D, a first gate electrode layer GT1 may be disposed on the first semiconductor pattern SP1. The first gate electrode layer GT1 may include a black scan line SBL, an emission control line EML, a write scan line SWL, a first initialization voltage line VIL, and a gate conductive pattern GT. The first initialization voltage line VIL, the write scan line SWL, the emission control line EML, and the black scan line SBL may be arranged to be spaced apart from each other in the vertical direction and extend in the horizontal direction. The first initialization voltage line VIL, the write scan line SWL, the emission control line EML, and the black scan line SBL may respectively correspond to the j-th first initialization voltage line VILj, the j-th write scan line SWLj, the j-th emission control line EMLj, and the j-th black scan line SBLj which are illustrated in FIG. 4A.

The first initialization voltage line VIL may be disposed at a position non-overlapping the first semiconductor pattern SP1. The write scan line SWL, the emission control line EML, the black scan line SBL, and the gate conductive pattern GT may overlap the first semiconductor pattern SP1. A portion, which overlaps the first semiconductor pattern SP1, of the first gate electrode layer GT1 may constitute a transistor.

Specifically, a portion, which overlaps the first semiconductor pattern SP1, of the write scan line SWL may function as a gate of the second transistor T2 (see FIG. 4A). The portion, which overlaps the first semiconductor pattern SP1, of the write scan line SWL may correspond to the third gate electrode G1c (see FIG. 5B).

A portion, which overlaps the first semiconductor pattern SP1, of the emission control line EML may function as a gate of each of the fifth and sixth transistors T5 and T6 (see FIG. 4A). The portion, which overlaps the first semiconductor pattern SP1, of the emission control line EML may correspond to the first gate electrode G1a (see FIG. 5B). A portion, which overlaps the first semiconductor pattern SP 1, of the black scan line SBL may function as a gate of each of the seventh and eighth transistors T7 and T8 (see FIG. 4A).

The gate conductive pattern GT may have a rectangular shape in plan view. The gate conductive pattern GT may be provided in plurality and the plurality of gate conductive patterns GT may be arranged to be spaced apart from each other in the horizontal direction. The gate conductive pattern GT may overlap a portion, which overlaps the first lower light blocking layer BML1, of the first semiconductor pattern SP1. The gate conductive pattern GT may function as a gate of the first transistor T1 (see FIG. 4A). The gate conductive pattern GT may correspond to the second gate electrode G1b (see FIG. 5B).

Additionally, a second doping process may be performed after the first gate electrode layer GT1 is formed. The first gate electrode layer GT1 may be used as a mask in the second doping process. A region of the first semiconductor pattern SP1, which do not overlap the write scan line SWL, the emission control line EML, the black scan line SBL, and the gate conductive pattern GT, may be formed through the doping process into the first sub-region N1a, the third sub-region N1b, the fifth sub-region N1c, the seventh sub-region N1d, and the ninth sub-region N1e which are illustrated in FIG. 5B.

Referring to FIG. 7E, a second gate electrode layer G3a may be provided after the first gate electrode layer GT1 is provided. The second gate electrode layer G3a may include a lower initialization scan line SIL_L, a lower compensation scan line SCL_L, and a first horizontal first driving voltage line VL1_H1. The lower initialization scan line SIL_L, the lower compensation scan line SCL_L, and the first horizontal first driving voltage line VL1_H1 may be arranged to be spaced apart from each other in the vertical direction and extend in the horizontal direction.

The first horizontal first driving voltage line VL1_H1 may extend in the horizontal direction, and include a portion having a relatively large width and a portion having a relatively small width. The portion having the relatively large width may overlap the gate conductive pattern GT, and a certain through-hole may be defined therein. The first horizontal first driving voltage line VL1_H1 may correspond to the second gate conductive pattern G2 (see FIG. 5B). That is, a portion, which has a relatively large surface area, of the first horizontal first driving voltage line VL1_H1 may overlap the second gate electrode G1b and constitute the capacitor Cst (see FIG. 4A), and the fifth connection electrode S1e (see FIG. 5A) may pass the second gate electrode layer GT2 through a through-hole and be stably connected to the second gate electrode G1b.

Thereafter, referring to FIG. 7F, a second semiconductor pattern SP2 may be provided. The second semiconductor pattern SP2 may be provided not to overlap the first semiconductor pattern SP1 in plan view. The second semiconductor pattern SP2 may be designed in a shape extending in the horizontal direction and including branches partially protruding in the vertical direction. The fourth transistor T4 (see FIG. 6A) and the third transistor T3 may be arranged in sequence along the branches of the second semiconductor pattern SP2. An end of each of the branches of the second semiconductor pattern SP2 may overlap and be connected to the first semiconductor pattern SP1 to constitute a node between the third transistor T3 and the first transistor T1.

A horizontal portion, which extends in the horizontal direction, of the second semiconductor pattern SP2 may overlap the first initialization voltage line VIL of the first gate electrode layer GT1 and may be connected to the first initialization voltage line VIL. The second semiconductor pattern SP2 may be provided as an oxide semiconductor.

Thereafter, referring to FIG. 7G, a third gate electrode layer GT3 may be provided. The third gate electrode layer GT3 may include an upper initialization scan line SIL_U, an upper compensation scan line SCL_U, and a bias voltage line VBL. The upper initialization scan line SIL_U, the upper compensation scan line SCL_U, and the bias voltage line VBL may be arranged to be spaced apart from each other in the vertical direction.

Each of the upper initialization scan line SIL_U and the upper compensation scan line SCL_U may have a linear shape extending in the horizontal direction. The upper initialization scan line SIL_U and the upper compensation scan line SCL_U may be provided not to overlap the first semiconductor pattern SP1 in plan view. The upper initialization scan line SIL_U and the upper compensation scan line SCL_U may be respectively connected to the lower initialization scan line SIL_L and the lower compensation scan line SCL_L, and may respectively correspond to the j-th initialization scan line SILj and the j-th compensation scan line SCLj which are illustrated in FIG. 4A. The fourth transistor T4 may be provided in a portion, which overlaps the second semiconductor pattern SP2, of the upper initialization scan line SIL_U, and the upper initialization scan line SIL_U may function as a gate of the fourth transistor T4. The third transistor T3 may be provided in a portion, which overlaps the second semiconductor pattern SP2, of the upper compensation scan line SCL_U, and the upper compensation scan line SCL_U may function as the gate of the third transistor T3.

The bias voltage line VBL may be designed to extend in the horizontal direction and in a zigzag shape with a bent portion. The sixth transistor T6 and the eighth transistor T8 may be provided in a portion, which overlaps the first semiconductor pattern SP1, of the bias voltage line VBL. The bias voltage line VBL may be connected to the eighth transistor T8 and supply a signal, while the bias voltage line VBL is not connected to but just overlaps the sixth transistor T6.

Thereafter, referring to FIG. 7H, a first source electrode layer ST1 may be provided. The first source electrode layer ST1 may include a horizontal data connection line H_DCL, a horizontal first initialization voltage line VL1_H, a second initialization voltage line VAIL, and a plurality of connection patterns CNa, CNb, CNc, CNd, CNe and CNf. Contact portions may be indicated on the horizontal data connection line H_DCL, the horizontal first initialization voltage line VL1_H, the second initialization voltage line VAIL, and the plurality of connection patterns CNa, CNb, CNc, CNd, CNe and CNf. The first source electrode layer ST1 may be connected to conductive patterns or semiconductor patterns disposed at a different layer through contact portions.

The horizontal data connection line H_DCL, a second horizontal first driving voltage line VL1_H2, the second initialization voltage line VAIL, and the plurality of connection patterns CNa, CNb, CNc, CNd, CNe and CNf may be arranged to be spaced apart from each other in plan view. The horizontal data connection line H_DCL may have a linear shape extending in the horizontal direction. The horizontal data connection line H_DCL may be connected to a vertical data connection line to be described later, through a contact portion.

The second horizontal first driving voltage line VL1_H2 may extend in the horizontal direction and include branches partially protruding in the vertical direction. The second horizontal first driving voltage line VL1_H2 may be connected to the first horizontal first driving voltage line VL1_H1 through a contact portion. In addition, the second horizontal first driving voltage line VL1_H2 may be connected, through a contact portion, to a second source electrode layer ST2 or a third source electrode layer ST3 which will be described later.

The second initialization voltage line VAIL may have a shape extending in the horizontal direction and partially bent. The second initialization voltage line VAIL may be connected to the first semiconductor pattern SP1 through a contact portion and provide the second initialization voltage Vaint (see FIG. 4A) to the seventh transistor T7.

First to fourth connection patterns CNa, CNb, CNc and CNd may be arranged to be spaced apart from each other between the horizontal data connection line H_DCL and the horizontal first driving voltage line VL1_H. A fifth connection pattern CNe may be disposed between the horizontal first driving voltage line VLL1_H and the second initialization voltage line VAIL. A sixth connection pattern CNf may be disposed on a lower side of the second initialization voltage line VAIL.

The first connection pattern CNa may have a bar shape extending in the horizontal direction. The first connection pattern CNa may be disposed at a position overlapping the first initialization voltage line VIL. The first connection pattern CNa may include a plurality of contact portions. The first connection pattern CNa may be connected to the first initialization voltage line VIL and the second semiconductor pattern SP2 through the contact portions and connect the first initialization voltage line VIL to the second semiconductor pattern SP2. The fourth transistor T4 may receive a voltage from the first initialization voltage line VIL through the first connection pattern CNa.

The second connection pattern CNb may be connected to a corresponding data line through a contact portion.

The third connection pattern CNc may have a shape extending in the horizontal direction and partially bent. The third connection pattern CNc may include contact portions defined in both ends thereof. The third connection pattern CNc may connect, through the contact portions, the second semiconductor pattern SP2 to the second gate electrode G1b corresponding to the gate of the first transistor T1. That is, the third connection pattern CNc may correspond to the first node N1 illustrated in FIG. 4A, and may correspond to the fifth connection electrode S1e illustrated in FIG. 5B.

The fourth connection pattern CNd may be a pattern having a bar shape extending in the vertical direction. The fourth connection pattern CNd may include a plurality of contact portions. The fourth connection pattern CNd may overlap each of the first semiconductor pattern SP1 and the second semiconductor pattern SP2. Through the contact portions, the fourth connection pattern CNd may connect the first semiconductor pattern SP1 to the second semiconductor pattern SP2 and be connected to each of the third transistor T3, the first transistor T1, and the sixth transistor T6. That is, the fourth connection pattern CNd may correspond to the second node N2 illustrated in FIG. 4A.

The fifth connection pattern CNe may be connected to the sixth transistor T6. The sixth connection pattern CNf may connect the bias voltage line VBL to the first semiconductor pattern SP1. That is, the eighth transistor T8 may receive a bias voltage Vbias from the bias voltage line VBL through the sixth connection pattern CNf.

Thereafter, referring to FIG. 7I, the second source electrode layer ST2 may be provided. The second source electrode layer ST2 may include data lines DLg1, DLb1, DLrl and DLg2, a first vertical first driving voltage line VL1_V1, and a plurality of connection patterns CN2.

Each of the data lines DLg1, DLb1, DLrl and DLg2 may have a shape extending in the vertical direction and partially bent. Additionally, the data lines DLg1, DLb1, DLrl and DLg2 may include first to fourth sub-data lines DLg1, DLb1, DLrl and DLg2 arranged in the horizontal direction. The examples about this overlap are stated in conjunction with FIG. 6B. However, this is illustrated as an example, and as long as the data lines are arranged not to overlap each other, the order and the arrangement shape thereof may be variously changed and are not limited to one or more embodiments.

The first vertical first driving voltage line VL1_V1 may extend in the vertical direction and have a partially large surface area. The first vertical first driving voltage line VL1_V1 may be disposed between a first sub-third data line DL3 and a first sub-first data line DL1. In FIG. 7H, the first vertical first driving voltage line VL1_V1 may be disposed between two sub-data lines.

The first vertical first driving voltage line VL1_V1 may have a shape having a partially large surface area so as to secure a sufficient surface area in a range in which the first vertical first driving voltage line VL1_V1 does not interfere with other components of the second source electrode layer ST2. Accordingly, a voltage drop may be reduced and a constant voltage may be uniformly provided to the entirety of the display panel. In addition, the first vertical first driving voltage line VL1_V1 may overlap first electrodes AE1, described later, in a large surface area in plan view. Accordingly, electrical interference between the first electrodes AE1 and electronic elements disposed below the second source electrode layer ST2 may be prevented.

The connection patterns CN2 may be connected to the connect portion of the horizontal data connection line H_DCL or be connected to the sixth transistor T6. When connected to the sixth transistor T6, the connection patterns CN2 may correspond to the eighth connection electrode S2a illustrated in FIG. 5B.

Thereafter, referring to FIG. 7J, the third source electrode layer ST3 may be provided. The third source electrode layer ST3 may include a vertical data connection line V_DCL, a plurality of shield patterns SLDa and SLDb, and a plurality of connection patterns CN3.

The vertical data connection line V_DCL may be disposed at a different layer from the data lines DLg1, DLb1, DLrl and DLg2. Accordingly, interference with the data lines DLg1, DLb1, DLrl and DLg2 may be reduced, and an arrangement degree of freedom of the vertical data connection line V_DCL may be improved regardless of the arrangement positions of the data lines DLg1, DLb1, DLrl and DLg2. The vertical data connection line V_DCL may be connected to the horizontal data connection line H_DCL of the second source electrode layer ST2 and be connected to a corresponding second data line of the second group of data lines DL_G2 (see FIG. 5A) disposed in the second area A2 (see FIG. 5A).

The shield patterns SLDa and SLDb may include a first shield pattern SLDa and a second shield pattern SLDb. Each of the first shield pattern SLDa and the second shield pattern SLDb may receive a constant voltage. Additionally, each of the first shield pattern SLDa and the second shield pattern SLDb may receive the first driving voltage ELVDD. However, this is described as an example, and the constant voltage provided (e.g., applied) to each of the first shield pattern SLDa and the second shield pattern SLDb may be a voltage other than the first driving voltage, and the first shield pattern SLDa and the second shield pattern SLDb may receive different constant voltages and are not limited to one or more embodiments. In various examples, constant voltages may be a supply voltage.

The first shield pattern SLDa and the second shield pattern SLDb may be spaced apart from each other in the horizontal direction and extend in the vertical direction. Each of the first shield pattern SLDa and the second shield pattern SLDb may have a shape having a partially different width in the extension direction. Additionally, the first shield pattern SLDa and the second shield pattern SLDb may have different shapes.

Each of the first shield pattern SLDa and the second shield pattern SLDb may be disposed at a position overlapping the first electrodes AE (see FIG. 5B) in plan view. The first shield pattern SLDa may overlap the first electrode AE and a second sub-data line DLb2 in plan view. The first shield pattern SLDa may electrically shield the second sub-data line DLb1. The first shield pattern SLDa may correspond one of the first and second source conductive patterns S3b and S3c.

The second shield pattern SLDb may overlap the first electrode AE, the third sub-data line DLrl, and the fourth sub-data line DLg2 in plan view. Here, the first electrode overlapped by the second shield pattern SLDb and the first electrode overlapped by the first shield pattern SLDa may be spaced apart from each other and be different electrodes. The second shield pattern SLDb may electrically shield the third sub-data line DLrl and the fourth sub-data line DLg2. The second shield pattern SLDb may correspond to the other of the first and second source conductive patterns S3b and S3c.

The connection patterns CN3 may be arranged to be spaced apart from each other. Each of the connection patterns CN3 may constitute a node which connects the pixel driving circuit and the first electrode AE disposed on the third source electrode layer ST3. Additionally, each of the connection patterns CN3 may be connected to the sixth transistor T6 (see FIG. 4B) and may correspond to the tenth connection electrode S3a illustrated in FIG. 5B.

According to one or more embodiments of the present disclosure, the vertical data connection line V_DCL may be provided in the third source electrode layer ST3 that is a different layer from the data lines DLg1, DLb1, DLrl and DLg2, thereby minimizing the interference with the data lines DLg1, DLb1, DLrl and DLg2. Thus, the vertical data connection line V_DCL may be disposed at various positions regardless of the arrangement positions of the data lines DLg1, DLb1, DLrl and DLg2, thereby improving a design degree of freedom.

In addition, according to one or more embodiments of the present disclosure, the number of sub-pixels and the number of the vertical data connection line V_DCL may be different. For example, two vertical data connection lines V_DCL may be disposed for six sub-pixels. The display panel according to one or more embodiments of the present disclosure may be designed so that two vertical data connection lines V_DCL per six sub-pixels are repeatedly disposed. That is, the pixels disposed in the second area A2 (see FIG. 5A) may be designed in pixel units in which two of the six sub-pixels are connected to the driving chip DIC (see FIG. 5A) through data connection lines, respectively, and four thereof are connected to the driving chip through data lines, respectively. However, this is described as an example, and the number of the vertical data connection line V_DCL may be changed, for example, only one per four sub-pixels or only two per five sub-pixels.

According to one or more embodiments of the present disclosure, a rate of the vertical data connection line V_DCL disposed per sub-pixel may be decreased. Accordingly, the number of the vertical data connection line V_DCL in the display panel may be decreased, and a distance between the data connection lines may be designed to be large, thereby improving the design degree of freedom. In addition, avoidance design of the vertical data connection line V_DCL and the first electrode AE may also be easily performed.

In addition, according to one or more embodiments of the present disclosure, the shield patterns SLDa and SLDb may be disposed in a space secured by the increase in the distance between the vertical data connection lines V_DCL. The shield patterns SLDa and SLDb may electrically shield the data lines DLr1, DLg1, DLb1 and DLg2 disposed below the shield patterns SLDa and SLDb. Accordingly, occurrence of mura defects such as copy mura may be suppressed, and the high-resolution display panel may be stably provided.

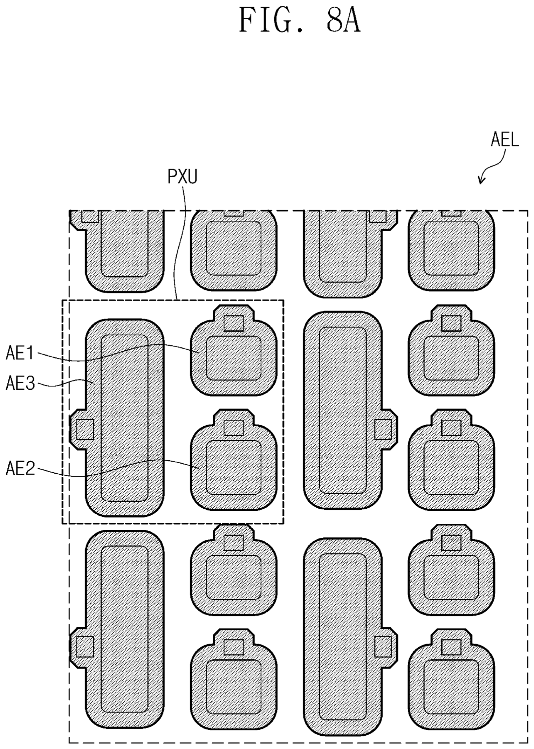

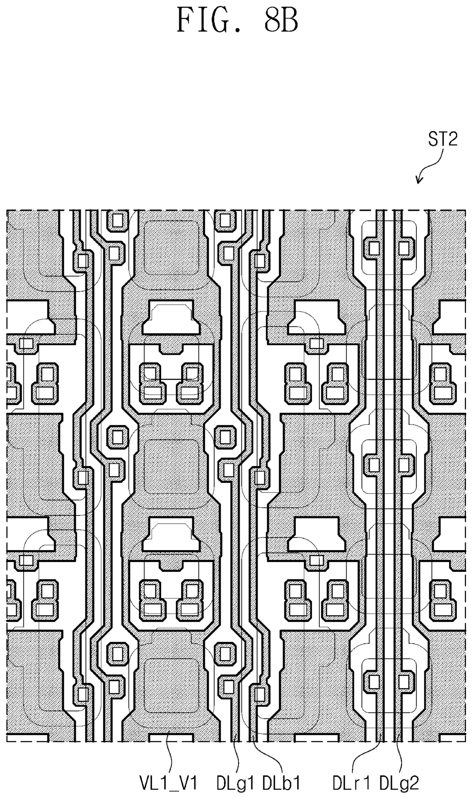

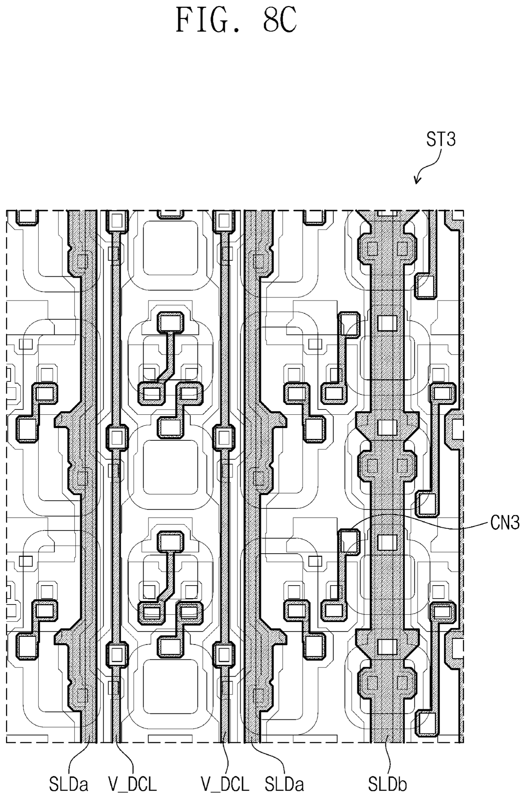

FIGS. 8A, 8B, and 8C each illustrate an example display panel are plan views of a display panel, according to one or more embodiments. In FIGS. 8A to 8C, an area including a plurality of pixel units is illustrated, and some components are omitted or selectively illustrated. according to one or more embodiments of the present disclosure may be described with reference to FIGS. 8A, 8B, and 8C. One or more components that are the same as or similar to those described in FIGS. 1-7J may be designated with the same or similar reference numerals. Redundant descriptions of the one or more components may be omitted.

FIG. 8A illustrates a first electrode layer AEL. In one or more embodiments, a pixel unit PXU may include three sub-pixels. The sub-pixels may include light emitting elements including a first anode electrode AE1, a second anode electrode AE2, and a third anode electrode AE3, respectively. Additionally, the first anode electrode AE1, the second anode electrode AE2, and the third anode electrode AE3 may respectively constitute a light emitting element which emits light of a red color, a light emitting element which emits light of a green color, and a light emitting element which emits light of a blue color.

FIG. 8B illustrates a second source electrode layer ST2 and, for easy description, illustrates the first electrode layer AEL together. As illustrated in FIG. 8B, a first sub-data line DLg1 may not overlap the first anode electrode AE1 and the second anode electrode AE2. The first sub-data line DLg1 may be disposed at a position non-overlapping the first electrodes AE1, AE2 and AE3 and have a shape in which some bent portions overlap the third anode electrode AE3. A second sub-data line DLb1 may be disposed at a position overlapping the third anode electrode AE3. A third sub-data line DLr1 and a fourth sub-data line DLg2 may be disposed at a position overlapping the first anode electrode AE1 and the second anode electrode AE2.

FIG. 8C illustrates a third source electrode layer ST3 and, for easy description, illustrates the first electrode layer AEL and the second source electrode layer ST2 together. A vertical data connection line V_DCL may be disposed at a position non-overlapping the first electrodes AE1, AE2 and AE3. For example, the vertical data connection line V_DCL may be disposed between first electrodes AE1, AE2 and AE3 spaced apart from each other in the first direction. Thus, electrical interference between the vertical data connection lines V_DCL and the first electrodes AE1, AE2 and AE3 may be reduced.

Shield patterns SLDa and SLDb may be disposed at a position overlapping the first electrodes AE1, AE2 and AE3 and data lines DLg1, DLb1, DLr1 and DLg2. For example, a first shield pattern SLDa may overlap the first sub-data line DLg1 and overlap the third anode electrode AE3. The first shield pattern SLDa may reduce an influence of the first sub-data line DLg1 on the third anode electrode AE3. The second shield pattern SLDb may overlap the third sub-data line DLr1 and the fourth sub-data line DLg2, and overlap the first anode electrode AE1 and the second anode electrode AE2. The second shield pattern SLDb may reduce an influence of the third sub-data line DLr1 and the fourth sub-data line DLg2 on the first anode electrode AE1 and the second anode electrode AE2.

In addition, according to one or more embodiments of the present disclosure, the shield patterns SLDa and SLDb may be disposed in a space secured by the reduction in the vertical data connection line V_DCL. The shield patterns SLDa and SLDb may electrically shield the data lines DLr1, DLg1, DLb1 and DLg2 disposed below the shield patterns SLDa and SLDb. Accordingly, occurrence of mura defects such as copy mura may be suppressed, and the high-resolution display panel may be stably provided.

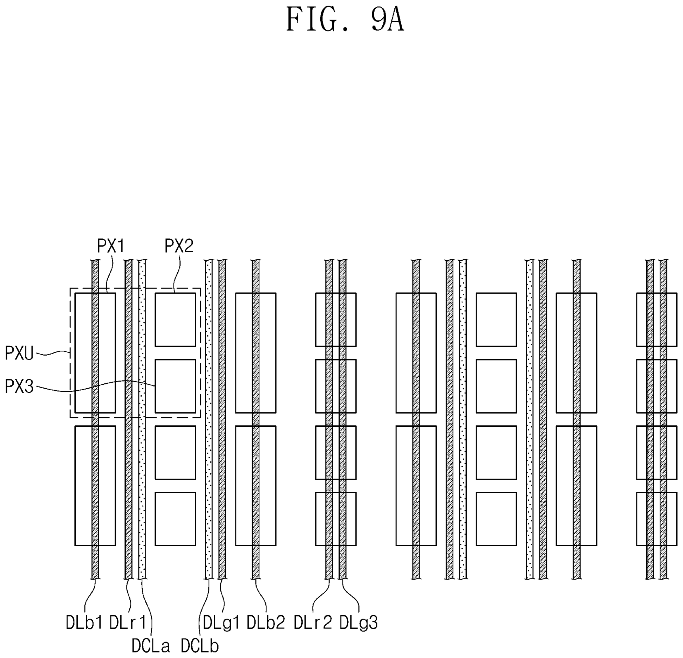

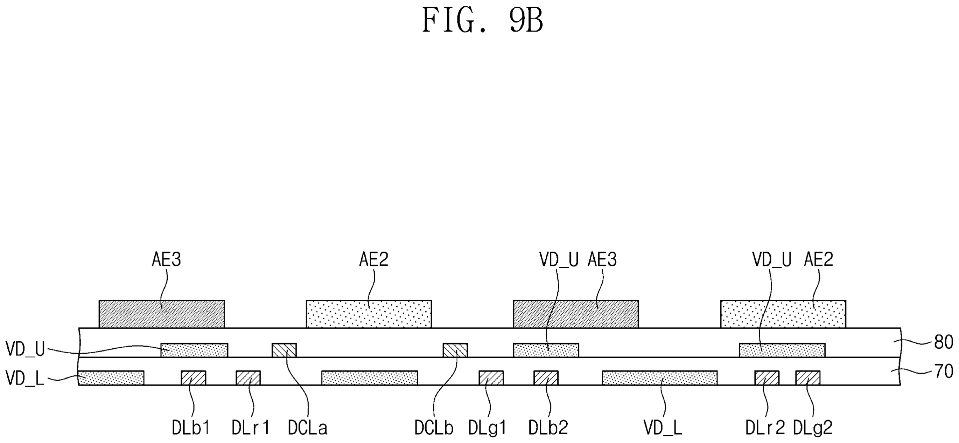

FIG. 9A illustrates a portion of an example display panel in a schematic plain view, according to one or more embodiments. FIG. 9B illustrates a portion of the example display panel illustrated in FIG. 9A in a cross-sectional view.

FIGS. 9A and 9B selectively illustrate some components for easy description. One or more embodiments of the present disclosure may be described with reference to FIGS. 9A and 9B. Meanwhile, the same/similar components as/to those described with reference to FIGS. 1-8C may be designated by the same/similar reference numerals or symbols, and the redundant contents may be omitted.

A pixel unit PXU including three sub-pixels PX1, PX2 and PX3 is described as an example. The three sub-pixels PX1, PX2 and PX3 may correspond to first electrodes of light emitting elements, respectively. Six data lines DLb1, DLr1, DLg1, DLb2, DLr2 and Dlg2 and two data connection lines DCLa and DCLb may be disposed per two pixel units PXU (e.g., a certain area) in each row, and this structure may be repeatedly arranged in a row direction. According to one or more embodiments of the present disclosure, the data connection lines DCLa and DCLb, the number of which is relatively smaller than the number of the data lines DLb1, DLr1, DLg1, DLb2, DLr2 and DLg2, may be disposed. Accordingly, the density of the data connection lines DCLa and DCLb may be decreased to variously design the arrangement of the data connection lines DCLa and DCLb.

A cross-sectional view illustrated in FIG. 9B is a cross-sectional view of components corresponding to the components illustrated in FIG. 8C. That is, FIG. 9B illustrates the second source electrode layer ST2 (see FIG. 8B), the third source electrode layer ST3 (see FIG. 8C), the first electrode layer AEL (see FIG. 8A), and insulating layers 70 and 80. As illustrated in FIGS. 9A and 9B, the data lines DLb1, DLr1, DLg1, DLb2, DLr2 and DLg2 may be arranged to be spaced apart from lower constant voltage lines VD_L in plan view and be covered by a seventh insulating layer 70. Among the data lines DLb1, DLr1, DLg1, DLb2, DLr2 and DLg2, some data lines DLb1, DLb2, DLr2 and DLg2 may be disposed at a position overlapping first electrodes AE2 and AE3 in plan view, and some data lines DLr1 and DLg1 may be disposed at a position non-overlapping the first electrodes AE2 and AE3 in plan view.

The data connection lines DCLa and DCLb and upper constant voltage lines VD_U may be disposed between the seventh insulating layer 70 and an eighth insulating layer 80. The data connection lines DCLa and DCLb may be disposed not to overlap the upper constant voltage lines VD_U in plan view. The data connection lines DCLa and DCLb may be disposed at a position non-overlapping the first electrodes AE2 and AE3 in plan view. Accordingly, the electrical interference of the data connection lines DCLa and DCLb, which affects the first electrodes AE2 and AE3, may be reduced. The upper constant voltage lines VD_U may be disposed at a position which overlaps, in plan view, the first electrodes AE2 and AE3 and the some data lines DLb1, DLb2, DLr2 and DLg2 of the data lines DLb1, DLr1, DLg1, DLb2, DLr2 and DLg2, disposed at the position overlapping the first electrodes AE2 and AE3 in plan view. The upper constant voltage lines VD_U may prevent the electrical interference of the data lines DLb1, DLb2, DLr2 and DLg2, which are disposed at the position overlapping the first electrodes AE2 and AE3 in plan view, from affecting the first electrodes AE2 and AE3. The upper constant voltage lines VD_U may correspond to the shield patterns SLDa and SLDb described above. According to one or more embodiments of the present disclosure, the shield patterns SLDa and SLDb may improve a display quality deterioration such as mura generated by a change in capacitance according to a signal applied to the data lines DLb1, DLb2, DLr2 and DLg2. Thus, a high-resolution display panel with improved electrical reliability may be easily provided.

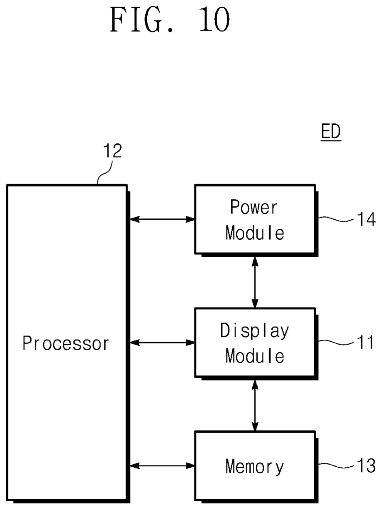

FIG. 10 illustrates an example block diagram of an electronic apparatus, according to one or more embodiments. Referring to FIG. 10, an electronic apparatus ED according to one or more embodiments may include a display module 11, a processor 12, a memory 13, and a power module 14 (e.g., power supply). The electronic apparatus ED may correspond to the electronic apparatus DD illustrated in FIG. 1.

The processor 12 may include at least one of a central processing unit (CPU), an application processor (AP), a graphic processing unit (GPU), a communication processor (CP), an image signal processor (ISP), or a controller. In one or more embodiments, the processor 12 may be provided as divided into two or more in a functional or structural aspect. For example, the processor 12 may include a main processor in the form of a first driving chip including the central processing unit, and a coprocessor in the form of a second driving chip including a controller which receives an image signal from the main processor and processes the image signal so as to be suitable for the specification of an interface with the display module 11.

The memory 15 may include at least one of a nonvolatile memory or a volatile memory. The memory 15 may store data information necessary for an operation of the processor 12 or the display module 11. When the processor 12 executes an application stored in the memory 15, an image data signal and/or an input control signal may be transmitted to the display module 11, and the display module 11 may process the received signal and output image information through a display screen.

The power module 14 may include a power supply module such as a power adapter or a battery device, and a power conversion module which converts the power supplied by the power supply module and generates power necessary for an operation of the electronic apparatus ED. The power conversion by the power conversion module may include DC-DC conversion, AC-DC conversion, and DC-AC conversion, and may not be limited thereto.

At least one of the components of the electronic apparatus ED described above may be included in the display device according to embodiments described above. In addition, some of individual modules included as functional in one module may be included in the display device, and others may be provided separately from the display device. For example, the display device may include the display module 11, and the coprocessor of the processor 12, and the main processor of the processor 12, the memory 13, and the power module 14 may be provided not in the display device but in another type of device in the electronic apparatus ED. As another example, the power module 14 may be provided in the display device and supply power to the processor 12 and the memory 13 provided in the electronic apparatus ED, not in the display device, and may not be limited to the examples described herein.

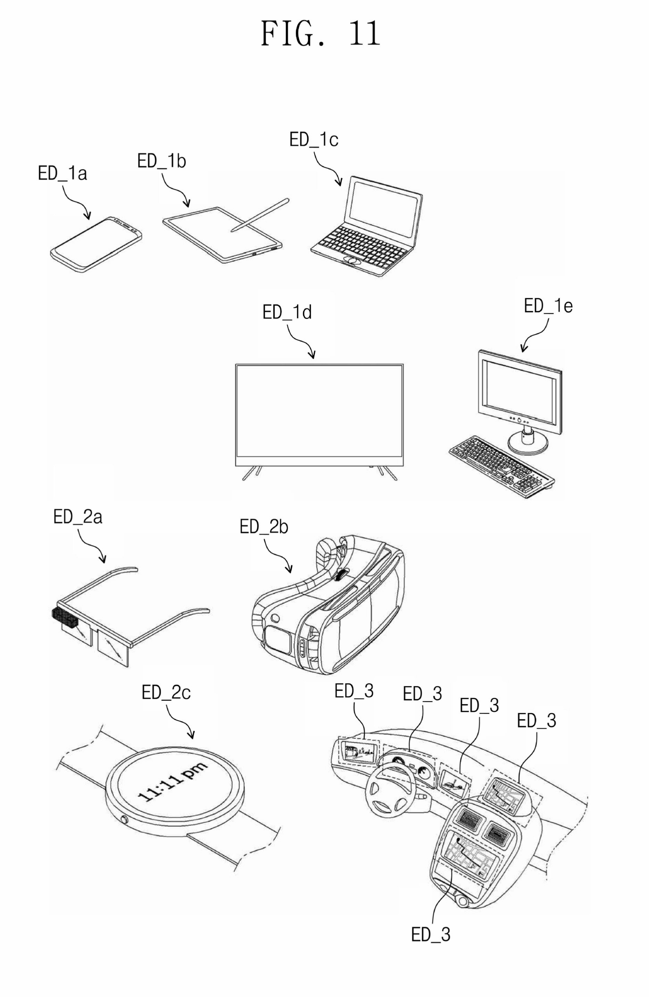

FIG. 11 illustrates an example schematic diagram of one or more electronic apparatuses, according to one or more embodiments.

Referring to FIG. 11, various electronic apparatuses to which a display device according to embodiments is applied may include not only an electronic apparatus for image display, e.g., a smartphone ED_1a, a tablet PC ED-1b, a laptop computer ED-1c, TV ED-1d, and a monitor for a desk computer ED-1e, but also a wearable electronic apparatus including a display module, e.g., smart glasses ED-2a, a head mounted display ED-2b, and a smartwatch ED-2c, and a vehicle electronic apparatus ED-3 including a display module, e.g., a vehicle instrument panel, a center fascia, a center information display (CID) disposed on a dashboard, and a room mirror display.

The electronic apparatus in FIG. 11 may include the components illustrated in FIG. 10. For example, the smartphone ED_1a may include the display module 11, the processor 12, the memory 13, and the power module 14 which are illustrated in FIG. 10. The smartphone ED_1a may further include a communication module and a battery device. Power provided by the battery device may be converted through the power module 14 and provided to the processor 12, the memory 13, and the display module 11. In one or more embodiments, a display device applied to the smartphone ED_1a may include the display module 11 and further include the power module 14. The processor 12 and the memory 13 may be provided in the form of a chip mounted on a mother board that is an external device, but are not limited thereto.

According to one or more embodiments of the present disclosure, the surface area of the non-display area may be decreased to achieve the borderless display panel. Moreover, according to one or more embodiments of the present disclosure, the electronic apparatus including the high-resolution display panel with the improved display quality may be achieved.

In the above, description has been made with reference one or more embodiments of the present disclosure, but those skilled or of ordinary skill in the art may understand that various modifications and changes may be made to one or more embodiments of the present disclosure insofar as such modifications and changes do not depart from the spirit and technical scope of one or more embodiments of the present disclosure set forth in the claims to be described later. Therefore, one or more embodiments of the present disclosure should not be construed as being limited to the specific examples described in the detailed description, but rather should be defined by the scope of the appended claims.

Unless explicitly described or implicitly understood from one or more embodiments of the present disclosure, at least one of the components, elements, modules or units (collectively "components" in this paragraph) represented by a block or an equivalent indication in the drawings including FIGS. 1-4A and 5A-10 may be implemented or embodied by analog and/or digital circuits including one or more of a logic gate, an integrated circuit, a microprocessor, a microcontroller, a memory circuit, a passive electronic component, an active electronic component, an optical component, and the like. Alternatively or additionally, these components may be implemented or embodied by software including one or more instructions stored in an internal or external storage medium that is readable by at least one processor. For example, the at least one processor may invoke at least one of the one or more instructions stored in the storage medium, and execute it, with or without using one or more other components under the control of the at least one processor. This allows the at least one processor to perform at least one function or operation described above as being performed by each of the components according to the at least one instruction invoked. Here, the at least one processor may include a central processing unit (CPU), a graphic processing unit (GPU), another type of microprocessor, not being limited thereto. In other examples, the at least one processor may be implemented in application specific integrated circuit (ASIC) and field-programmable gate array (FPGA).

In an embodiment, vertical lines of the plurality of data connection lines are at a different layer from the plurality of data lines.

In another embodiment the circuit layer further comprises a conductive pattern between the plurality of data lines and the plurality of light emitting elements, and the conductive pattern is configured to receive a constant voltage.

In another embodiment the conductive pattern overlaps one of the plurality of light emitting elements in a third direction crossing the first direction and the second direction, and the conductive pattern overlaps, in the third direction, one or more of the plurality of data lines that overlap the one of the plurality of light emitting elements.

In another embodiment one light emitting element of the first light emitting element, the second light emitting element, and third light emitting element overlaps at least one of the plurality of first data lines in the third direction, wherein a conductive pattern is between the one light emitting element and the at least one of the plurality of first data lines, and wherein the conductive pattern overlaps the one light emitting element and the at least one of the plurality of first data lines in the third direction.

In another embodiment, an electronic apparatus comprises: a display panel: a processor connected to the display panel; and a power supply configured to supply power to the processor, wherein the display panel comprises: a base layer comprising a display area and a non-display; a circuit layer on the base layer; and an element layer on the circuit layer, the element layer comprising a plurality of light emitting elements each comprising a first electrode, wherein the circuit layer comprises: a plurality of pixel driving circuits respectively connected to the plurality of light emitting elements; a plurality of data lines comprising a plurality of first data lines connected to a first group of the plurality of pixel driving circuits, and a plurality of second data lines spaced from the plurality of first data lines in a first direction and connected to a second group of the plurality of pixel driving circuits; a plurality of data connection lines respectively connected to the plurality of second data lines in the display area; and a shield pattern which is at the same layer as the plurality of data connection lines, and is configured to receive a constant voltage, wherein each of the plurality of data connection lines comprises a vertical line extending in a second direction crossing the first direction, and a horizontal line extending in the first direction and connected to the vertical line, wherein vertical lines of the plurality of data connection lines are at a different layer from the plurality of data lines, wherein the vertical lines are respectively between first electrodes of the plurality of light emitting elements spaced from each other in the first direction, and wherein the shield pattern overlaps at least a portion of the plurality of data lines in a third direction crossing the first direction and the second direction.

In an embodiment the horizontal line is at a different layer from the vertical line and the plurality of data lines.

The invention as defined in Claim 1 addresses the challenge of reducing the non-display "dead space" in high-resolution displays, which is often consumed by a large number of signal lines. The core technical effect is achieved through a specific routing architecture where a second group of data lines are re-routed via data connection lines (DCLs) that are partially disposed within the display area itself. The key feature of the claim, which specifies that at least two data lines are located between adjacent vertical connection lines, means that the vertical connection lines are less dense than the data lines they serve. According to the description, this arrangement provides several distinct advantages. Firstly, the increased distance between the vertical connection lines helps to prevent electrical interference between them. Secondly, by routing these connections within the display area, the space they occupy in the non-display area is significantly reduced, which decreases the overall bezel size and enables the design of a "borderless" display panel. Finally, this architecture provides greater design freedom in placing the connection lines, which simplifies the design process for achieving a high-resolution display.

For item 2, which specifies a complete electronic apparatus with a processor and power supply, the technical effect is to define a self-contained, functional product. By further incorporating a shield pattern that receives a constant voltage and is strategically placed to overlap the data lines, this embodiment provides the significant advantage of suppressing electrical interference. This shielding prevents signals on the data lines from affecting the light emitting elements, which directly improves display quality by reducing visual artifacts like "copy mura." The arrangement of the vertical connection lines on a different layer from the data lines enhances design freedom and further minimizes interference, resulting in a final product, such as a smartphone, that features a high-resolution, borderless display with superior electrical reliability.

In an embodiment the horizontal and vertical lines of the data connection lines are on different layers enables a multi-layered interconnect structure. The technical effect is that it allows for the creation of a two-dimensional grid where conductive paths can cross over one another without creating an electrical short. This is advantageous for increasing the routing density and design freedom of the circuit layer, which is essential for connecting the re-routed data lines to the driving chip in a compact manner.

In another embodiment the vertical connection lines are placed in a layer "above" the data lines, meaning further from the base layer, provides the advantage of greater design flexibility. This specific vertical stack-up allows these connection lines to be routed with fewer constraints from the underlying data line layout. The technical effect is an improved design degree of freedom and enhanced electrical reliability for the overall display panel.

In another embodiment, the second group of pixel driving circuits is physically closer to the non-display area is a direct consequence of the invention's core architecture. The technical effect is to define the physical layout where pixels on the outer edges of the display have their data lines re-routed inward. This configuration is advantageous because it is integral to achieving the primary goal of reducing the bezel size and creating a borderless display.

In another embodiment a "pixel unit" comprises at least two light emitting elements connected to a first data line. The technical effect is to establish the basic repeating structural unit of the display. This is advantageous for defining how these fundamental units are connected to the directly-driven first data lines, forming the basis of the matrix addressing scheme used to generate an image.

In another embodiment, which specifies a three-color pixel unit where only one of the three elements is connected to a re-routed data connection line, the technical effect is a more efficient implementation of the re-routing scheme at the sub-pixel level. This is highly advantageous because it significantly reduces the total number of required vertical connection lines. This simplification of the layout improves design freedom and makes it easier to achieve a high-resolution display.

In another embodiment, having the shield pattern overlap the first electrodes provides the technical advantage of enhanced electrical shielding. The effect of this arrangement is to prevent electrical interference from nearby data lines from affecting the voltage at the pixel electrodes. This leads to more stable pixel operation and an overall improvement in display quality.

In another embodiment, which specifies that the shield pattern receives the same first driving voltage as the pixel's power supply, the technical effect is the creation of a highly stable and well-defined electrical environment. This is advantageous because the shield pattern acts as an effective and constant potential plane, maximizing its ability to shield the pixel from electrical noise and ensuring reliable performance and high image quality.

In another embodiment, the shield pattern overlaps multiple data lines that run under a single electrode provides comprehensive shielding in high-density areas. In a high-resolution display where wiring is dense, this ensures the shield pattern provides robust protection against electrical interference from multiple sources. The advantage is improved electrical reliability under the most demanding layout conditions.

In another embodiment, which defines a specific ratio of six data lines for every two vertical connection lines, the technical effect is a concrete implementation of the density-reduction principle. This is advantageous because it allows for the high density of data lines needed for high resolution while using a much lower density of re-routing lines. This maximizes the space between the vertical connection lines, which reduces interference while still minimizing the wiring area in the bezel.

In another embodiment, constructing the pixel driving circuits using both silicon (LTPS) and oxide semiconductors provides the advantage of combining the best properties of two different technologies. The technical effect is an optimized pixel circuit where high-mobility LTPS transistors are used for driving current and low-leakage oxide transistors are used for switching. This hybrid approach leads to improved pixel performance, higher efficiency, and reduced power consumption.

In another embodiment, fabricating the horizontal connection line on the same layer as the gate electrode patterns offers a significant manufacturing advantage. The technical effect is a streamlined production process, as different functional parts of the circuit can be patterned in the same fabrication steps. This leads to a more efficient and cost-effective manufacturing flow for the complex circuit layer.

In another embodiment, the manufacturing method itself provides the overarching advantage of producing a display device that embodies all the structural benefits of the invention. By following the specified steps of disposing the layers and making the connections, a manufacturer can create a high-resolution display panel with a reduced bezel, greater design freedom, and improved electrical reliability.

In another embodiment, adding the step of disposing a conductive pattern at the same layer as the vertical connection lines integrates a shielding element directly into the manufacturing flow. The advantage is the creation of a display with inherently improved electrical reliability. This step proactively suppresses potential mura defects and other display artifacts by building in a shield to prevent electrical interference.

## Claims

1. An electronic apparatus (ED) comprising:
a base layer (110) comprising a display area (DA) and a non-display area (NDA);
a circuit layer (120) on the base layer (110); and
an element layer (130) on the circuit layer (120), the element layer (130) comprising a plurality of light emitting elements (LD),
wherein the circuit layer (120) comprises:
a plurality of pixel driving circuits (PDC) respectively connected to the plurality of light emitting elements (LD);
a plurality of data lines (DL) comprising a plurality of first data lines (DL_G1) connected to a first group of the plurality of pixel driving circuits (PDC), and a plurality of second data lines (DL_G2) spaced apart from the plurality of first data lines (DL_G1) in a first direction (DR1) and connected to a second group of the plurality of pixel driving circuits (PDC); and
a plurality of data connection lines (DCL) respectively connected to the plurality of second data lines (DL_G2) in the display area (DA),
wherein each of the plurality of data connection lines (DCL) comprises a vertical line (V_DCL) extending in a second direction (DR2) crossing the first direction (DR1), and a horizontal line (H_DCL) extending in the first direction (DR1) and connected to the vertical line (V_DCL), and
wherein at least two data lines of the plurality of data lines (DL) are between two adjacent vertical lines (V_DCL) of the plurality of data connection lines (DCL).

2. The electronic apparatus (ED) of claim 1, further comprising: a processor (12) connected to the circuit layer (120); and a power supply (14) configured to supply power to the processor (12),
wherein the light emitting elements (LD) each comprise a first electrode (AE), and
wherein the circuit layer (120) further comprises: a shield pattern (SLDa, SLDb) which is at the same layer as the vertical lines (V_DCL) of the plurality of data connection lines (DCL), and is configured to receive a constant voltage,
wherein the vertical lines (V_DCL) of the plurality of data connection lines (DCL) are at a different layer from the plurality of data lines (DL), wherein the vertical lines (V_DCL) are respectively between the first electrodes (AE) of the plurality of light emitting elements (LD) spaced from each other in the first direction (DR1), and wherein the shield pattern (SLDa, SLDb) overlaps at least a portion of the plurality of data lines (DL) in a third direction (DR3) crossing the first direction (DR1) and the second direction (DR2).

3. The electronic apparatus (ED) of claim 1 or 2, wherein horizontal lines (H_DCL) of the plurality of data connection lines (DCL) are at a different layer from the vertical lines (V_DCL).

4. The electronic apparatus (ED) of claim 2, wherein the vertical lines (V_DCL) are above the plurality of data lines (DL).

5. The electronic apparatus (ED) of claim 1, wherein the second group of the plurality of pixel driving circuits (PDC) is closer to the non-display area (NDA) in the first direction (DR1) than the first group of the plurality of pixel driving circuits (PDC).

6. The electronic apparatus (ED) of claim 1, wherein each of a plurality of pixel units (PXU) comprises at least two of the plurality of light emitting elements (LD), and is connected to at least one of the plurality of first data lines (DL_G1).

7. The electronic apparatus (ED) of claim 6, wherein the each of the plurality of pixel units (PXU) further comprises:
a first light emitting element (AE1) configured to emit light of a first color;
a second light emitting element (AE2) configured to emit light of a second color different from the first color, and spaced from the first light emitting element (AE1) in the first direction (DR1); and
a third light emitting element (AE3) configured to emit light of a third color different from the first color and the second color, and spaced from the first light emitting element (AE1) in the first direction (DR1) and from the second light emitting element (AE2) in the second direction (DR2),
wherein one of the first light emitting element (AE1), the second light emitting element (AE2), and the third light emitting element (AE3) is connected to one of vertical lines of the plurality of data connection lines (DCL), and
wherein others of the first light emitting element (AE1), the second light emitting element (AE2), and the third light emitting element (AE3) are respectively connected to corresponding first data lines (DL_G1) of the plurality of first data lines.

8. The electronic apparatus (ED) of claim 2, wherein at least a portion of the plurality of data lines (DL) overlaps the first electrodes (AE) in the third direction (DR3), and
wherein the shield pattern (SLDa, SLDb) overlaps the first electrodes (AE) in the third direction (DR3).

9. The electronic apparatus (ED) of claim 8, wherein the plurality of pixel driving circuits (PDC) is configured to receive a first driving voltage (ELVDD) and a second driving voltage (ELVSS) which are different from each other,
wherein a second electrode (CE) opposing the first electrodes (AE) of the plurality of light emitting elements (LD) is configured to receive the second driving voltage (ELVSS), and
wherein the shield pattern (SLDa, SLDb) is configured to receive the first driving voltage (ELVDD).

10. The electronic apparatus (ED) of claim 8, wherein at least two data lines (DL) of the plurality of data lines overlap one of the first electrodes (AE) in the third direction (DR3), and
wherein the shield pattern (SLDa, SLDb) overlaps the at least two data lines in the third direction (DR3).

11. The electronic apparatus (ED) of claim 2, wherein the plurality of data lines (DL) comprises six data lines arranged in the first direction (DR1) in a certain area, and the vertical lines (V_DCL) comprise two vertical lines arranged in the first direction (DR1) in the certain area.

12. The electronic apparatus (ED) of claim 3, wherein the plurality of pixel driving circuits (PDC) comprises a first semiconductor pattern (SP1) comprising a silicon semiconductor, and a second semiconductor pattern (SP2) comprising an oxide semiconductor.

13. The electronic apparatus (ED) of claim 12, wherein the plurality of pixel driving circuits (PDC) comprises a first gate electrode pattern (GT1) overlapping the first semiconductor pattern (SP1) in the third direction (DR3), and a second gate electrode pattern (GT3) overlapping the second semiconductor pattern (SP2) in the third direction (DR3), and
wherein the horizontal line (H_DCL) is on the first gate electrode pattern (GT1) and the second gate electrode pattern (GT3).

14. A method of manufacturing a display device, the method comprising:
providing a base layer (110) including a display area (DA) and a non-display area (NDA);
disposing a circuit layer (120) on the base layer (110), the circuit layer (120) including a plurality of pixel driving circuits (PDC), a plurality of data lines (DL), and a plurality of data connection lines (DCL), the plurality of data lines (DL) including a plurality of first data lines (DL_G1) and a plurality of second data lines (DL_G2), each of the plurality of data connection lines (DCL) including a vertical line (V_DCL) extending in a second direction (DR2) crossing a first direction (DR1), and a horizontal line (H_DCL) extending in the first direction (DR1) and connected to the vertical line (V_DCL);
disposing an element layer (130) to be on the circuit layer (120), the element layer (130) including a plurality of light emitting elements (LD);
respectively connecting the plurality of pixel driving circuits (PDC) to the plurality of light emitting elements (LD);
connecting the plurality of first data lines (DL_G1) to a first group of the plurality of pixel driving circuits (PDC) and the plurality of second data lines (DL_G2) to a second group of the plurality of pixel driving circuits (PDC), the plurality of second data lines (DL_G2) being spaced from the plurality of first data lines (DL_G1) in the first direction (D1);
respectively connecting the plurality of data connection lines (DCL) to the plurality of second data lines (DL_G2) in the display area (DA); and
disposing at least two data lines of the plurality of data lines (DL) between two adjacent vertical lines (V_DCL) of the plurality of data connection lines (DCL).

15. The method of claim 14, further comprising:
disposing a conductive pattern between the plurality of data lines (DL) and the plurality of light emitting elements (LD) at the same layer as vertical lines (V_DCL) of the plurality of data connection lines (DCL).
